**Europäisches Patentamt**

(19) **European Patent Office**

**Office européen des brevets**

(11) **EP 1 126 625 B1**

(12) **EUROPÄISCHE PATENTSCHRIFT**

(45) Veröffentlichungstag und Bekanntmachung des Hinweises auf die Patenterteilung:
**15.02.2006 Patentblatt 2006/07**

(51) Int Cl.:
*H04B 1/69* (2006.01)

(21) Anmeldenummer: **01110727.3**

(22) Anmeldetag: **03.11.1997**

(54) **Übertragungsverfahren und Anordnung zur Durchführung des Verfahrens**

Method of transmission and device to carry out said method

Procédé et dispositif de transmission

(84) Benannte Vertragsstaaten:
**AT CH DE ES FI FR GB IT LI NL SE**

(30) Priorität: **01.11.1996 DE 19646745**

(43) Veröffentlichungstag der Anmeldung:
**22.08.2001 Patentblatt 2001/34**

(62) Dokumentnummer(n) der früheren Anmeldung(en) nach Art. 76 EPÜ:
**97949876.3 / 0 938 782**

(73) Patentinhaber: **Nanotron Technologies GmbH 10555 Berlin (DE)**

(72) Erfinder:
• **Koslar, Manfred**
**10629 Berlin (DE)**
• **Ianelli, Zbigniew**
**13355 Berlin (DE)**

(74) Vertreter: **Eisenführ, Speiser & Partner Patentanwälte Rechtsanwälte Postfach 10 60 78 28060 Bremen (DE)**

(56) Entgegenhaltungen:
WO-A-95/20277       DE-A- 3 216 666
GB-A- 2 208 462      US-A- 4 255 791
US-A- 5 070 500      US-A- 5 105 294
US-A- 5 325 394

• KOWATSCH ET AL.: "Spread-Spectrum-übertragung analoger Signale mit Chirp-Modulation" ARCHIV FÜR ELEKTRONIK UND ÜBERTRAGUNGSTECHNIK, Bd. 36, Nr. 7, Juli 1982 (1982-07), Seiten 299-304, XP002061685

**EP 1 126 625 B1**

**Beschreibung**

Die Erfindung betrifft ein Übertragungsverfahren gemäß dem Oberbegriff des Anspruchs 1, sowie eine Sender-Empfänger-Anordnung zur Durchführung des Verfahrens gemäß dem Oberbegriff des Anspruchs 7.

Bei den bekannten Übertragungsverfahren wird die zu übertragende Nachricht im Sender einem hochfrequenten Trägersignal aufmoduliert und über die Übertragungsstrecke dem Empfänger übermittelt, der zur Rückgewinnung der Nachricht einen entsprechenden Demodulator aufweist. Zur Modulation analoger Signale besteht eine umfangreiche Literatur. Die modernen Nachrichtenverfahren benutzen digitale oder digitalisierte Informationen, da derartige Signale mittels der Prozessortechnik auf dem Signalweg mit den heute zur Verfügung stehenden Mitteln auch bei großem Informationsanfall schnell und kostengünstig verarbeitet werden können.

Liegt das zu übertragende Nachrichtensignal in digitalisierter Form als Bitfolge vor - wie es in modernen Mobilfunknetzen der Fall ist - so erfolgt die Modulation durch Änderung der Frequenz bzw. Phase oder der Amplitude des Trägersignals in Abhängigkeit von dem jeweiligen Informationswert der zu übertragenden Bitfolge. Zur digitalen Modulation des Trägersignals sind aus COUCH, L.W.: Digital and Analog Communication Systems, 4th Edition, Macmillan Publishing Company (1993) unterschiedliche digitale Modulationsverfahren bekannt, beispielsweise die Amplitudentastung (ASK: Amplitude Shift Keying), die Zweiphasenumtastung (2-PSK: Phase Shift Keying) oder die Zweifrequenzumtastung (2-FSK: Frequency Shift Keying), oder neuere Verfahren wie die Spreizmodulationsverfahren. Im Empfänger erfolgt jeweils die Demodulation entsprechend dem senderseitig angewandten Modulationsverfahren und damit die Rückgewinnung des digitalen Nachrichtensignals als Bitfolge in Form von aufeinanderfolgenden Impulsen. Ein bekanntes Modulationsverfahren der Nachrichtentechnik stellt dabei - wie erwähnt - auch die Winkelmodulation als Oberbegriff von Frequenz- oder Phasenmodulation dar. Bei den bekannten Verfahren, wie beispielsweise im Dokument US 5,105,294 beschreiben, dient diese Modulationsart aber ausschließlich dazu, die Nachricht einem Träger aufzuprägen.

Der Nachteil besteht bei allen derartigen Verfahren grundsätzlich darin, daß die Qualität des empfängerseitig zurückgewonnenen Nachrichtensignals mit der Entfernung zwischen Emfpänger und Sender mit Störungen auf der Übertragungsstrecke stark abnimmt.

Um bei einer Nachrichtenübertragung auf einer störungsbehafteten Übertragungsstrecke eine gewünschte Reichweite mit einer vorgegebenen Störsicherheit zu erreichen, darf die Sendeleistung deshalb einen vorbestimmten Wert nicht unterschreiten.

Zum einen hat die somit erforderliche große Sendeleistung den Nachteil, daß die abgestrahlte Leistung während des Sendebetriebs entsprechend hoch ist, was insbesondere bei batteriebetriebenen Geräten, wie in Mobiltelefonen, wegen der raschen Batterieerschöpfung störend ist. Zum anderen bestehen Befürchtungen, daß die von dem Sender ausgehende elektromagnetische Strahlung zu einer Schädigung des menschlichen Körpers führen kann, was insbesondere bei Mobiltelefonen wegen des vergleichsweise geringen Abstands zum Benutzer zu berücksichtigen ist.

Der Erfindung liegt die Aufgabe zugrunde, ein Übertragungs - verfahren der eingangs genannten Art bzw. eine Sender-Empfängner-Anordnung zur Durchführung des Verfahrens zu schaffen, welches - bei im übrigen mindestens gleichbleibender Übertragungsqualität - eine Verringerung der Sendeleistung bzw. eine Erhöhung der Reichweite ermöglicht.

Diese Aufgabe wird, ausgehend von einem Verfahren gemäß dem Oberbegriff des Anspruchs 1, durch dessen kennzeichnende Merkmale bzw. - hinsichtlich der Anordnung zur Durchführung des Verfahrens - durch die Merkmale des Anspruchs 7 gelöst.

Die Erfindung schließt die technische Lehre ein, "Faltimpulse" zwischen Sender und Empfänger zu übertragen, das sind besonders ausgestaltete Impulse die nachstehend näher definiert sind. Diese Faltimpulse können aufgrund ihrer besonderen Eigenschaften im Empfänger nicht nur zur Amplitudenerhöhung durch entsprechende Kompressionsverfahren mit entsprechend angepaßten Dispersionsfiltern verwendet werden, sondern können aufgrund ihrer besonderen hochkorrelativen Eigenschaften zur zusätzlichen korrelativen und autokorrelativen Unterdrückung des Rauschens gegenüber dem Signal genutzt werden. Die besondere Modulation und die spezielle Zusammensetzung dieser hier "Faltimpulse" genannten Übertragungselemente erlauben eine Erhöhung des Signal/Rauschverhältnisses in der analogen Signalaufbereitung beim Empfänger. Auf diese Weise läßt sich über eine Verbesserung des Signal/Rauschverhältnisses im Empfänger wahlweise eine Verringerung der Sendeleistung bzw. eine Vergrößerung von Reichweite oder eine Verringerung der Fehlerrate erzielen.

Unter dem Begriff "Faltimpuls" ist hierbei und im folgenden jeweils die Überlagerung (Superposition) mindestens zweier entgegengesetzt winkelmodulierter Impulse (Komponenten) - in ihrer Grundform auch als "Chirpsignale" bezeichnet - mit im wesentlichen gleicher Dauer zu verstehen, wobei die Winkelmodulation der beiden Impulse derart erfolgt, daß sich die Frequenz der einen Komponente während der Impulsdauer im mathematischen Sinne monoton steigend - und bei der zweiten Impulskomponente monoton fallend ändert. Der Faltimpuls ist also dadurch zu definieren, daß er gleichzeitig aus mindestens zwei winkelmodulierten Impulsen (Chirpsignalen) mit zueinander gegenläufig sich ändernder Frequenz besteht, wobei die relative Phasenlage der Komponenten zueinander auch noch zur Unterscheidung solcher Signale verwendet werden kann.

**2**

Gemäß den unabhängigen Ansprüchen wird Schutz im Zusammmenhang mit der Erzeugung von frequenzmodulierten Chirpsignalen Geanspruch

Zum besseren Verständnis der Chirpsignale, der Komponenten der "Faltimpulse", sei zunächst grundsätzlich auf deren Eigenschaften und anschließend auf die speziellen vorteilhaften Eigenschaften der Faltimpulse eingegangen.

Ein winkelmodulierter Impuls einer bestimmten Zeitdauer $\Delta t$ mit einem bestimmten Frequenzhub $\Delta f$ ist unter anderem durch sein Zeit-Bandbreite-Produkt $\psi = \Delta t \cdot \Delta f$ kennzeichenbar. Durch spezielle, sogenannte "dispergierende Filter", das sind Vierpole mit einem definierten differentiellen Laufzeitverhalten, kann man solche winkelmodulierten Impulse im Empfänger in der Zeitachse zusammenschieben, das heißt komprimieren. Die Energie des ursprünglichen Impulses der Dauer $\Delta t$ [s] mit der Amplitude $U_0$ [V] am Widerstand $R_1$ [$\Omega$], die durch den Ausdruck $(U_0^2 \cdot \Delta t) / R_1$ gegeben ist, bleibt bei der Kompression bei zunächst als verlustlos angenommener Dispersion erhalten. Demnach kann man für den kürzeren komprimierten Impuls der Dauer $\delta$ die Energie mit $(U^2 \cdot \delta)/R_1$ ansetzen, wobei $U$[V] die sich aus der Kompression ergebende erhöhte Impulsamplitude darstellt.

Also wird

$$(U_O{}^2 \cdot \Delta t) \; / \; R_1 = (\hat{U}^2 \cdot \delta) \; / \; R_1.$$

Demnach ist das Verhältnis der Quadrate der Spannungen gleich dem umgekehrten Verhältnis der Zeiten zwischen dem ursprünglich gesendeten Impuls der Dauer $\Delta t$ und der mittleren Dauer $\delta$ des komprimierten Impulses, also gilt

$$\hat{U}^2 = U_O{}^2 \cdot \Delta t \; / \; \delta = U_O{}^2 \cdot \Delta t \; \cdot \; \Delta f = U_O{}^2 \cdot \psi,$$

wobei $\delta = 1/\Delta f$ ist. Demnach wird die Spannung im. Empfänger durch die Kompression um einen Faktor erhöht, der direkt der Wurzel des Zeitbandbreiteproduktes entspricht.

Also bewirkt der Chirpimpuls, wenn er im Empfänger durch dispergierende Filter komprimiert wird, eine erste Verbesserung des Signal/Rauschverhältnisses. Weil das Signal/Rauschverhältnis $\rho$ [dB] durch das zwanzigfache des Logarithmus des Verhältnisses der Signalspannung $\hat{U}$ [V] zur Rauschspannung $Ur$[V] definiert ist, gilt mit obigen Gleichungen:

$$\rho = 20\log \; (\hat{U}/Ur) = 10\log\{(U_O{}^2/ \, Ur^2)\,\psi\} = 10\log(U_O{}^2/ \, Ur^2) + 10\log\psi$$

wobei ersichtlich ist, daß das S/N-Verhältnis $\rho$ direkt um den Teil $+10\log\psi$ verbessert wird.

Diese Zusammenhänge sind bekannt und werden zur Zeit nur in der Radartechnik und zur Übertragung von Signalen in optischen Leitern aus anderen Gründen verwendet, jedoch nicht zur allgemeinen Nachrichtenübertragung. Die Chirpsignale jedoch haben noch eine andere bisher nicht genutzte Eigenschaft, die eine zweite Verbesserung des S/N-Verhältnisses zulassen.

Durch Mehrfachkorrelation mehrerer Chirpsignale kann in Form der Faltimpulse eine automatische Korrelation im Empfänger erzielt werden, die über die durch die Kompression erzielbare S/N-Verbesserung oben dargestellter Art hinaus durch zum Beispiel Multiplikation der Faltimpulse einen weiteren zusätzlichen sehr gravierenden S/N-Gewinn bewirken kann.

Das liegt an der Möglichkeit, Kombinationen solcher Chirpimpulse in Form von Faltimpulsen zu schaffen, die bei Anwendung dispersiver Filteranordnungen es ermöglichen, die in der Zeitachse ursprünglich unterschiedlich verlaufenden Komponenten durch die Verzögerungseigenschaften der Filter zeitlich so zu verlagern, daß koinzidente Signale generiert werden können derart, daß diese zeitliche Verschiebung zur Korrelation der Signale genutzt werden kann.

Damit lassen sich die Faltsignale als hoch korrelierte Nachrichtensignale charakterisieren, die aus mehreren Gründen ideal zur Nachrichtenübertragung genutzt werden können. Sie bedingen zwar zunächst wegen der Länge und der Bandbreite einen Verlust an Bitrate, erlauben aber auf der anderen Seite, hier der Empfängerseite, einen deutlichen Gewinn an Rauschreduktion verschiedenster Störer, auch des weißen Rauschens, also des unvermeidlichen thermischen Rauschens.

Hochkorreliert sind sie deshalb, weil mehrere physikalische Konventionen zwischen Sender und Empfänger getroffen werden müssen und die dispersiven Filter auch auf die Phasencharakteristik des gesendeten Faltimpulses im Empfänger abgestimmt sein müssen. Das sind:

1. die Frequenzlage der Trägerfrequenz (Mittenfrequenz),
2. die Bandbreite der Frequenz der winkelmodulierten Impulse (Frequenzhub),
3. die Winkelmodulationszeitcharakteristik der Sendeimpulskomponenten,
4. die Zeitdauer des Faltimpulses,
5. die Richtung der Winkelmodulation (monoton wachsende oder fallende Frequenz mit der Zeit) und deren Schachtelung,
6. die Phasenlage zu einem vorgegebenen Zeitpunkt innerhalb der Zeitdauer des winkelmodulierten Impulses und die relative Phasenlage der Komponenten zueinander und
7. die Amplitude des winkelmodulierten Impulses.

Bis auf den siebten können diese Parameter zwischen Sender und Empfänger frei vereinbart werden, um bei entsprechend gestalteten Empfängern als Informationsträger zu dienen.

Sie erlauben eine breite Varianz der Parameter, die der Informationsübertragung zu Gute kommt. Die Übertragungsgeschwindigkeit, also die Bitrate, war bisher das wichtigste Ziel der Gestaltung von Übertragungsstrecken. Sie wird zwar durch die in der Zeitdauer verlängerten Impulse oder durch deren größere Bandbreite zunächst herabgesetzt; die Kanalkapazität kann auch dadurch gesteigert werden, daß man durch Zeit- oder Frequenzmultiplexverfahren verschiedene Kanäle unabhängig voneinander zu unterschiedlichen Zeiten oder bei unterschiedlichen Frequenzen oder unterschiedlicher Frequenzzeitmodulationscharakteristik und unterschiedlichen Faltimpulskombinationen betreiben kann. Die Bitrate pro Kanal mal die Anzahl der möglichen Kanäle ergibt dann erst die gesamte Menge übertragbarer Informationsinhalte pro Zeiteinheit.

Also erlaubt die Varierbarkeit obiger Parameter, die über die Zeit- und Frequenzlage hinausgehen, einen zusätzlichen Gewinn, wenn die obengenannten Größen in unterschiedlichen Konventionen zwischen Sender und Empfänger vereinbart werden.

Diese Überlegungen zeigen, daß Chirpimpulse, speziell Faltimpulse, quasi als spezielles "Trägersubstrat" zur Übertragung der eigentlichen Nachricht aufgefaßt werden können. Diese Modulation geschieht also unabhängig von der für die Nachricht vorgesehenen Modulation, die möglichst zu der ersten orthogonal sein sollte. Diese hier zur Klarstellung als Trägersubstratmodulation zu bezeichnende Modulation stellt also eine zusätzliche Beziehung oder Korrelation zwischen Sender und Empfänger her und dient dazu, das Rauschen, vornehmlich das thermische Rauschen, und auch andere Störer zu eliminieren, weil diese diese Zusatzmodulation nicht aufweisen können.

Das hier dargestellte Übertragungsverfahren zur Übertragung von Nachrichtensignalen zwischen einem Sender und einem Empfänger über eine störerbehaftete Übertragungsstrecke stellt eine Kombination aus einer der bekannten Pulsmodulationsarten oder Pulscodemodulationsarten und einer speziellen zur ersten Modulationsart orthogonal wirkenden Winkelmodulation dar, wobei die Basisbandsignale der Nachricht, zum Beispiel in Pulspositionsmodulation (PPM) oder. Pulscodemodulation (PCM) oder Impulsamplitudenmodulation (PAM) oder in Differentieller Pulscodemodulation (DPCM) oder als Pulsdeltamodulation (PDM) oder Spreizmodulationsverfahren (Spread Spectrum Modulation) oder einer der bekannten Modifikationen dieser Arten auf eine dem Stand der Technik entsprechende Weise erzeugt werden können.

Diese nachrichtenbezogene Modulationen der analogen oder digitalen Signale werden jedoch hier auf eine Trägerschwingung aufmoduliert, die in der Sendeeinrichtung während der Pulsdauer nicht wie üblich von einer in ihrer Frequenz konstanten Trägerfrequenz erzeugt wird, sondern die Trägerfrequenz wird zusätzlich derart mehrfach winkelmoduliert, daß die beim Faltimpuls zueinander reversen Winkelmodulationskomponenten einerseits und die Amplitudenänderung als Signalinformation oder die Pulsabstandswerte (bei PPM) des winkelmodulierten Trägers andererseits als Kombination voneinander unabhängiger Modulationsarten, sogenannter "zueinander orthogonaler Modulationsarten", gleichzeitig und zu unterschiedlichem Zweck vorgenommen werden, wobei die bekannten Modulationsarten zur Übertragung der Nachricht dienen und darüber hinaus die Winkelmodulationskombinationen in der besonderen Form der Faltimpulse als hochkorrelierbare Signale unter Verwendung dispersiver Filteranordnungen zur korrelativen Rauschunterdrückung genutzt werden.

Die Folge solcher Faltimpulse wird über die Übertragungsstrecke, die allgemein durch Störer anderer Sender und durch weiße Rauschanteile gestört wird, zum Empfänger übertragen. Der Begriff "Übertragungsstrecke" ist hierbei allgemein zu verstehen und umfaßt drahtlose Übertragungsstrekken, bei denen die Informationsübertragung vom Sender zum Empfänger mittels elektromagnetischer Wellen erfolgt, sowie leitungsgebundene Übertragungsstrecken, bei, denen Sender und Empfänger vorzugsweise über Lichtwellenleiter, Koaxialkabel oder einfache elektrische Leitungen miteinander verbunden sind.

Darüber hinaus ist die Erfindung auch bei einer Datenspeicherung beispielsweise auf magnetischen Datenträgern anwendbar. In diesem Fall ist der Sender als Schreibeinheit ausgeführt, die die Daten auf den Datenträger schreibt, während der Empfänger als Leseeinheit ausgebildet ist, die die gespeicherten Daten aus dem Datenträger ausliest.

Der Empfänger kann die beiden zueinander orthogonalen Modulationsarten demodulieren, wobei der Empfänger zu diesem Zweck im Verlauf seines Blockdiagrammes zwischen Antenne und Gleichrichter erfindungsgemäß dispersive Filter der definierten Art aufweist, wobei solche Filteranordnungen angegeben werden, die der automatischen Signalrauschverbesserung durch die korrelativen Eigenschaften des Faltimpulses dienen und gleichzeitig diese Signale noch durch Kompression in ihrer Amplitude zu erhöhen vermögen.

Da die in den Faltimpulsen enthaltenen Chirpsignale einen Gewinn an Signal/Rauschverhältnis durch die Komprimierbarkeit der Signalamplitude erlauben, und die Dispersionsfilter so angeordnet werden können, daß deren zueinander inverse Eigenschaften zwei zueinander spiegelsymmetrische Ausgangssignale aus den Chirpsignalkomponenten der Faltimpulse erzeugen, lassen sich diese zeitgleich auftretenden korrelierten Impulse addieren, multiplizieren oder subtrahieren, ausschneiden oder unterdrücken und erlauben auf diese Weise eine quasi-autokorrelative Hervorhebung des Signales gegenüber dem Rauschen.

Eine weitere sehr entscheidende Überlegung läßt sich aus dem Umstand ableiten, daß die Anstiegszeit des komprimierten Impulses der vollen Bandbreite des Chirpsignales entspricht und in seiner zeitlichen Position sehr genau innerhalb einer Empfangsanordnung definiert ist. Demzufolge ist dieses Übertragungsverfahren für eine Pulspositionsmodulation (PPM) geradezu prädestiniert. Selbst wenn man immer zwei Chirpimpulse aussenden würde, deren erster als Zeitreferenzpunkt für den Abstand zum zweiten ihm folgenden Impuls diente, wäre die gesamte Dauer nur 2,5 mal der Pulsdauer. Ein solches Signal kann für eine analoge Signalübertragung, aber auch zur Übertragung digitaler Signale verwendet werden, insofern wird also die durch die erhöhte Bandbreite ebenfalls erhöhte Kanalkapaazität genutzt.

Die dispersiven Filteranordnungen, wie sie später in Applikationsbeispielen aufgeführt werden, können gleichzeitig mehrere Funktionen erfüllen und reduzieren damit den notwendigen Aufwand in möglichen Empfängerstrukturen.

Erstens bewirken sie eine Überhöhung des Signals gegenüber dem Rauschen durch die bloße Kompression der Faltimpulskomponenten.

Zweitens kann durch diese Anordnungen gleichzeitig erreicht werden, daß die Faltimpulskomponenten durch entsprechende Anordnungen der Filter zu koinzidenten spiegelsymmetrischen Signalen führen, die durch selbsttätige Korrelation zu einem weiteren Gewinn bezüglich des S/N-Verhältnisses führen.

Drittens kommt hinzu, daß bei einer Multiplikation der koinzidenten und komprimierten Signale bei einer autokorrelativen Multiplikation von Signalen gleicher Frequenzlage (spiegelsymmetrische Frequenzlage) ohne weitere Filter gleichzeitig eine automatische, multiplikative und kohärente Demodulation der komprimierten Signale bewirkt wird, die sonst nur durch aufwendige PLL-Schaltungen erzielt werden könnte.

Leitet man im Empfänger den Faltimpuls, wie er eingangs definiert wurde, über zwei zueinander parallel geschaltete Dispersionsfilter mit zueinander reverser komplementärer Dispersion, entstehen an den beiden Ausgängen dieser Filter zwei spiegelsymmetrische Signale.

Die beiden Dispersionsfilter haben bei winkelmodulierten Faltimpulsen zwei invers zueinander wirkende Kennlinien. Während der Phasengang über der Frequenz jeweils parabelförmig ist, ist die daraus abgeleitete Gruppenlaufzeit über der Zeit eine Gerade, die mit steigender Frequenz auch ansteigt, während das andere Filter in der Charakteristik der Gruppenlaufzeit komplementär wirkt, also die Gruppenlaufzeit mit steigender Frequenz größer wird.

Die Gruppenlaufzeitcharakteristik ist also bei linearfrequenzmodulierten Impulsen eine Gerade, bei entsprechend nicht-linearer Frequenzmodulation stellt die jeweilige Gruppenlaufzeit des dispersiven Filters die jeweilige innere Funktion zur Modulationscharakteristik dar. Bei komplementär nicht-linear modulierten Faltsignalkomponenten müssen also die demodulierten Dispersionsfilter entsprechende komplementäre Gruppenlaufzeitcharakteristiken aufweisen.

Da die superponierten Anteile des Faltimpulses aus zwei Komponenten bestehen und diese beiden Anteile auf zwei zueinander invers wirkende, parallelgeschaltete Dispersionsfilter geschaltet werden, finden vier Vorgänge gleichzeitig statt:

Bei der Komponente, die eine sich mit der Zeit erhöhende Frequenz (positiver Frequenzverlauf) aufweist, werden durch eines der beiden parallel geschalteten Filter mit einer negativen Gruppenlaufzeitcharakteristik über der Frequenz die höheren Frequenzanteile verzögert. Hierdurch werden die ursprünglich positiv gechirpten Signale komprimiert, wobei die gegenläufige, negativ gechirpte Faltimpulskomponente zur doppelten Dauer des Eingangsimpulses zeitlich expandiert wird.

Das andere Filter wirkt umgekehrt, weil es die niedrigeren Frequenzen stärker verzögert als die hohen Frequenzen (positive Gruppenlaufzeitcharakteristik), wobei die von hohen Frequenzen zu niedrigeren Frequenzen verlaufende Komponente komprimiert und die von niedrigeren zu hohen Frequenzen verlaufende Pulskomponente zur doppelten Dauer des Eingangsimpulses expandiert wird.

Die beiden Dispersionsfilter führen also jeweils bei einem der beiden in ihrer Überlagerung den Faltimpuls bildenden winkelmodulierten Impulse zu einer zeitlichen Kompression mit einer dementsprechenden Amplitudenerhöhung, wohingegen der andere Impulsanteil zur doppelten Dauer expandiert wird, was zu einer entsprechenden Amplitudenverringerung führt.

Da das Rauschen am Eingang im Vergleich zu einem derartigen Signal nicht korreliert ist, aber aufgrund der Dispersionseigenschaften der dispersiven Filter nicht gleichförmig verändert wurde, ist das Rauschsignal am Ausgang der beiden Filter zum Signal unkorreliert.

Somit kann man im analogen Bereich des Empfängers durch analoges Signalprocessing bestimmte Prinzipien anwenden, die zur Rauschunterdrückung genutzt werden können, und zwar zum großen Teil unabhängig voneinander, wie Simulationen gezeigt haben.

Zur praktischen Umsetzung der systembedingten Dispersionsfilter dienen hierbei heute nach dem Stand der Technik bevorzugt Oberflächenwellenfilter (SAW-Filter: Surface Acoustic Waves), da sich derartige Filter mit hoher Reproduktionsgenauigkeit und Stabilität herstellen lassen. Darüber hinaus bieten derartige Oberflächenwellenfilter den Vorteil, daß sich Amplitudengang und Phasengang unabhängig voneinander dimensionieren lassen, was die Möglichkeit eröffnet, das in jedem Empfänger erforderliche schmalbandige Bandpaßfilter und das Dispersionsfilter in einem Bauteil zu verwirklichen. Die Ausführung der Dispersionsfilter als SAW-Filter Modul ermöglicht weiterhin vorteilhaft die Integration mehrerer Dispersionsfilter zusammen mit Tiefpaßfiltern, Addierern und Subtrahierern auf einem Substrat, so daß ein kompaktes SAW-Bauteil als Kern der erfindungsgemäßen Anordnung geschaffen werden kann. Bevorzugt also wird eine SAW-Filter-Baueinheit auf einem Substrat, bestehend aus zwei parallelen und zueinander revers wirkenden Dispersionsfiltern mit zwei Ein- und Ausgängen und zusätzlichen Ausgängen jeweils für Summe und Differenz der Ausgangssignale. Diese Funktionen könnten alle auf einem einzigen Substrat untergebracht werden. Die normalerweise differentiellen Ein- und Ausgänge wurden hier der Einfachheit halber für Blockschaltbilder nur durch eine Leitung dargestellt.

Das erfindungsgemäße Übertragungsverfahren ist hinsichtlich der senderseitig vorgenommenen Winkelmodulation ersichtlich nicht auf eine lineare Frequenzänderung während der Impulsdauer beschränkt. Entscheidend ist, daß die Laufzeitcharakteristik der empfängerseitig vorgesehenen Dispersionsfilter an die senderseitig vorgenommene Winkelmodulation der beiden in ihrer Überlagerung den Faltimpuls bildenden Impulse derart angepaßt ist, daß am Ausgang der empfängerseitig angeordneten Dispersionsfilter jeweils ein kombiniertes Signal erscheint, das aus einem zeitlich komprimierten Impuls mit entsprechend erhöhter Amplitude und einem zeitlich expandierten Impuls mit entsprechend verringerter Amplitude besteht.

Diese beiden -kombinierten Signale können nun entweder addiert, subtrahiert, oder multipliziert werden und wie gezeigt wird hierdurch oder durch Unterdrücken oder Ausschneiden der koinzidenten Anteile zur Verbesserung des S/N- Verhältnisses im Empfänger genutzt werden.

Die Addition der kombinierten Signale ergibt eine Superposition der komprimierten Signalanteile sowie eine Überlagerung der doppelt gedehnten Chirpsignale und eine Addition des auf dem Übertragungsweg hinzugekommenen Rauschens. Da die komprimierten Signale koinzident auf die Addierstufe gelangen, werden deren Signalamplituden addiert, also verdoppelt. Demnach erhöht sich das Signal um 6 dB. Das Rauschen jedoch, das nicht korreliert ist und dessen Phase und Amplitude schwanken, kann nur bezüglich der Leistung addiert werden. Also nimmt seine Amplitude statistisch nur um 3 dB zu. Demnach ergibt sich eine mittlere Signal/Rauschverbesserung von 3 dB, weil beim Signal aufgrund des gleichzeitigen Auftretens die Spannungen addiert werden und beim Rauschen aufgrund des statistischen Auftretens nur die Leistungen addiert werden. Die Koinzidenz der spiegelsymmetrisch komprimierten Komponenten am Ausgang der empfängerseitig angeordneten Dispersionsfilter führt also nur für ein Faltsignal bei ihrer Summation zu einem S/N-Gewinn.

Die Subtraktion der kombinierten Signale führt je nach der relativen Phasenlage der Faltbestandteile des Faltsignales zueinander zu einer Signal/Rauschverbesserung. Je nach Phasenlage der Signale sind Subtraktion und. Addition nur komplementäre Vorgänge zueinander.

Bei der Multiplikation der beiden durch die parallel geschalteten Dispersionsfilter am Ausgang entstehenden kombinierten Signale entstehen ähnliche Verhältnisse, wie sie von der Autokorrelation her bekannt sind.

Bei dem bekannten Autokorrelationsverfahren werden periodische oder quasi-periodische Signale durch eine Verzögerungsleitung um die Periodendauer versetzt und mit dem eintreffenden - nicht über eine Verzögerungsleitung geleiteten - Signal multipliziert. Die Gleichförmigkeit des Signales nach einer Periodendauer führt zur Quadrierung der dann koinzidenten Signalamplituden. Das Rauschen jedoch, weil über die Verzögerungsleitung nicht korrelierbar, wird hierbei bekanntermaßen unterdrückt. Die Autokorrelation gehört zu den effizientesten - allerdings nicht linearen - Verfahren um periodische oder quasi-periodische. Signale gegenüber dem Rauschen hervorzuheben, also den Signalrauschabstand zu erhöhen.

Der gleiche physikalische Effekt läßt sich sehr vorteilhaft für das Faltsignal erzielen. Da das Faltsignal derart zusammengesetzt wurde, daß es durch zwei parallel geschaltete Dispersionsfilter mit zueinander inverser Dispersionrichtung zwei zueinander symmetrische kombinierte und koinzidente Ausgangssignale erzeugt, die dadurch gekennzeichnet sind, daß in deren zeitlicher Mitte in beiden Zweigen sich jeweils komprimierte Signalanteile befinden, die durch Kompression überhöht sind, ergibt die Multiplikation dieser überhöhten auf einen engen Zeitbereich komprimierten Signale eine Quadrierung der Signalamplituden.

Das Rauschen jedoch ist nicht korreliert und wurde außerdem durch die dispersiven Filter in seinem zeitlichen Verlauf gedehnt, also auch in seiner Amplitude abgesenkt. Die Multiplikation der Rauschanteile führt also zu einer im Verhältnis zu dem quadrierten Signal sehr viel kleineren Amplitude.

Demnach tritt ein ähnlicher physikalischer Effekt wie bei der Autokorrelation periodischer Signale hier bei einem aperiodischen Signal auf. Obwohl die Autokorrelationsgleichung für Faltimpulse anders aussehen würde als für periodische Signale, weil nicht die Signale durch eine Verzögerungsleitung um die Periodendauer versetzt werden, sondern zwei frequenzabhängige Verzögerungsleitungen mit zueinander reverser Dispersionsrichtung vorliegen, die auf das Faltsignal wechselseitig so wirken, daß die komprimierten Signale und die jeweils gedehnten Signale in einer Art zeitlicher Spiegelsymmetrie koinzident auftreten und bei der wechselseitigen Multiplikation eine gravierende Rauschunterdrükkung bewirkt wird.

Während die normale Autokorrelation periodische oder quasi-periodische Signale voraussetzt, ist sie auf digitale Folgen, zum Beispiel Impuls-Code-Modulations-verfahren, nicht anwendbar. Das Faltsignal jedoch ist ein Signal bestimmter Dauer, das sich nicht wiederholt. Trotzdem ist es in sich selbst, wie nachgewiesen wurde, automatisch korrelierbar.

Die Erzeugung der winkelmodulierten Impulse, die in ihrer Überlagerung jeweils einen Faltimpuls bilden, kann nach dem Stand der Technik auf verschiedene Arten erfolgen, von denen im folgenden einige kurz beschrieben werden.

In einer Variante der Erfindung wird zunächst näherungweise ein Dirac-Impuls erzeugt und einem Tiefpaßfilter zugeführt, dessen Filterkennlinie kurz vor Erreichen der Grenzfrequenz eine Überhöhung aufweist und den Dirac-Impuls somit in einen si-Impuls (Spaltimpuls) wandelt, dessen Form durch die bekannte si-Funktion si $(x) = {}^{\sin x} / x$ beschrieben wird. Das si-förmige Ausgangssignal des Tiefpaßfilters wird anschließend auf einen Amplitudenmodulator gegeben, welcher der Trägerschwingung eine si-förmige Hüllkurve aufprägt. Wird das auf diese Weise erzeugte Signal einer Parallelschaltung zweier dispergierender Filter mit zueinander reverser Charakteristik zugeführt, so erscheinen am Ausgang der beiden Filter zwei zueinander revers winkelmodulierte Chirpsignale, bei deren Addition oder Subtraktion zwei unterschiedliche Faltimpulse entstehen, die als hier sogenannte "Summen- oder Differenzsignale" - beides sind Faltimpulse mit unterschiedlicher relativer Phasenlage zueinander - bezeichnet werden können.

Gemäß einer bevorzugten Ausführung der Erfindung erfolgt die Erzeugung der frequenzmodulierten Impulse dagegen mittels einer PLL-Schleife (PLL: P̲hase L̲ocked L̲oop) und eines spannungsgesteuerten Oszillators (VCO: V̲oltage C̲ontrolled O̲scillator). Die einzelnen Impulse des in digitaler Form vorliegenden Eingangssignals werden hierzu zunächst durch einen Integrator in sägezahnförmige Impulse umgewandelt, wobei die Anstiegsrichtung der einzelnen Impulse von der Amplitude des Eingangssignals abhängt. Das auf diese Weise erzeugte Signal wird dann zur Ansteuerung des VCO's verwendet, so daß die Frequenz eines Ausgangsimpulses während der Impulsdauer in Abhängigkeit vom Pegel des Eingangssignals linear zunimmt oder fällt. Werden durch eine geeignete Schaltung dieser Art zwei gegenläufige Chirpsignale gleichzeitig erzeugt, so können die Faltsignale entweder durch Addition oder Subtraktion als Summen- oder Differenzsignale erzeugt werden.

Nach einer weiteren vorteilhaften Ausgestaltung der Erfindung erfolgt die Erzeugung der frequenzmodulierten Impulse im Sender durch eine digitale Singalverarbeitungseinheit, was vorteilhaft die Realisation beliebiger Frequenzverläufe während der Impulsdauer ermöglicht.

In der Regel liegen die zu übertragenden Informationen in digitaler Form als binäres Signal vor, wobei die Aufprägung dieser Informationen auf die Faltimpulse in einer einfachen Variante der Erfindung dadurch erfolgt, daß nur bei einem logischen HIGH-Pegel des informationstragenden Eingangssignales ein Faltimpuls übertragen wird, während ein logischer LOW-Pegel des Eingangssignals zu einer Übertragungspause führt, wobei auch eine Umkehrung dieser Konvention möglich ist.

Entscheidend ist in dieser Variante der Erfindung lediglich, daß nur ein logischer Pegel des informationstragenden Eingangssignales aktiv übertragen wird.

In der bevorzugten Ausführungsform der Erfindung wird dagegen sowohl ein logischer HIGH-Pegel als auch ein logischer LOW-Pegel des informationstragenden Eingangssignals aktiv übertragen, was zu einer erhöhten Störsicherheit führt. Hierzu werden senderseitig in Abhängigkeit von dem jeweiligen binären Wert des Eingangssignals zwei unterschiedliche Faltimpulse erzeugt.

So ist es günstig, bei einem HIGH-Pegel des informationstragenden Eingangssignals einen Faltimpuls zu übertragen, der aus der Summe zweier entgegengesetzt winkelmodulierter Impulse besteht. Bei einem LOW-Pegel des Eingangssignals wird dann entsprechend ein Faltimpuls erzeugt, der aus einer Subtraktion zweier entgegengesetzt winkelmodulierter Impulse besteht. Demnach unterscheiden sich diese zwei unterschiedlichen Faltimpulse durch die jeweilige Phasenlage der Faltimpulskomponenten zueinander.

Ferner sind diese Signale für fast alle bisher bekannten Modulationsverfahren anwendbar. Ideal jedoch sind sie für die Puls-Positions-Modulation (PPM) geeignet, bei der die Reduktion der Bitrate hier nicht so ins Gewicht fällt, weil hierzu maximal nur zwei Pulse erforderlich sind, bei synchronen Verfahren sogar nur ein Impuls.

Weiterhin kann es günstig sein, sowohl logische LOW-Pegel als auch logische HIGH-Pegel des informationstragenden binären Eingangssignals aktiv durch jeweils einen Faltimpuls zu übertragen, wobei die Position der übertragenen Faltimpulse in Abhängigkeit von dem jeweiligen Wert des informationstragenden Eingangssignals vorgegeben wird.

Die Erfindung ist in dieser Variante der Puls-Positions-Modulation nicht auf binäre Eingangssignale beschränkt, die lediglich zwei unterschiedliche Signalpegel aufweisen, sondern auch allgemein mit digitalen Eingangssignalen verwendbar, wobei entsprechend der möglichen Anzahl unterschiedlicher Signalpegel des Eingangssignals auch Faltimpulse unterschiedlicher Position einen mehrfachen bit-Level repräsentieren können.

Das erfindungsgemäße Übertragungsverfahren ist jedoch nicht auf die vorstehend exemplarisch beschriebenen Modulations-verfahren beschränkt, sondern läßt sich mit einer Vielzahl von Modulationsverfahren kombinieren, die u.a. in der eingangs genannten Druckschrift beschrieben sind, auf deren Inhalt insoweit Bezug genommen wird. Sogar die modernen Spreizmodulationsverfahren können mit dem winkelmodulierten Trägersubstrat versehen werden, um hier eine Reduktion des weißen Rauschens zu bewirken, was bisher nicht möglich war.

Andere vorteilhafte Weiterbildungen der Erfindung sind in den Unteransprüchen gekennzeichnet bzw. werden nachstehend zusammen mit der Beschreibung der bevorzugten Ausführungsbeispiele der Erfindung anhand der Figuren näher dargestellt. Es zeigen:

Figur 1a          ein Blockschaltbild einer Sendeanordnung als Beispiel zur Anwendung des erfindungsgemäßen Übertragungsverfahrens.

Figur 1b bis 1f    verschiedene Rauschunterdrückungsmodule als Blockschaltbilder zur Anwendung in verschiedenen Ausführungsformen von Empfängern zum Empfang des von dem in der Figur 1a dargestellten durch den Sender erzeugten und übertragenen Signals.

Figur 2a bis 2p    den Signalverlauf an verschiedenen wichtigen Punkten innerhalb der in den vorangegangenen Figuren dargestellten Blockschaltbilder sowie

Figur 3a bis 3d    verschiedene Ausführungsformen von Empfängern unter Verwendung der Rauschunterdrückungsschaltungen nach den Figuren 1b bis 1f als Beispiele für Empfängeranordnungen zur Nutzung des Übertragungsverfahrens.

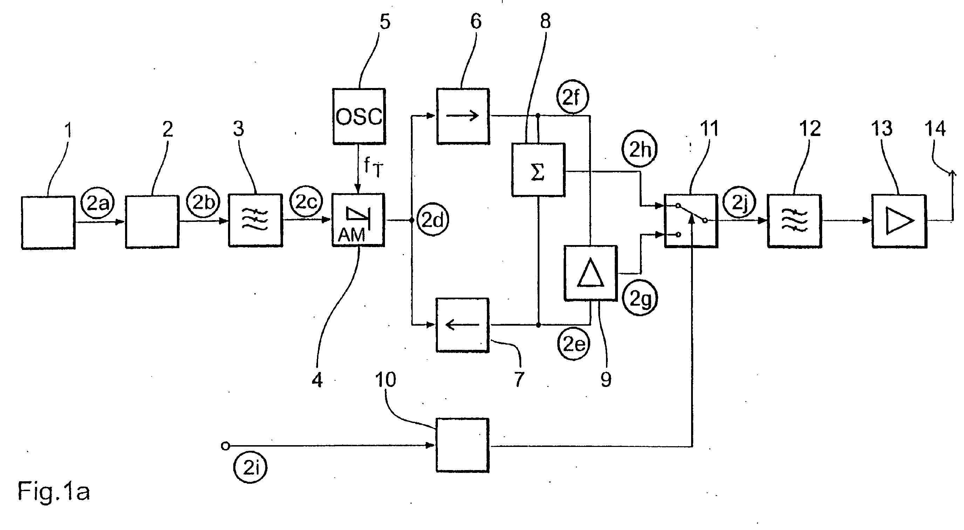

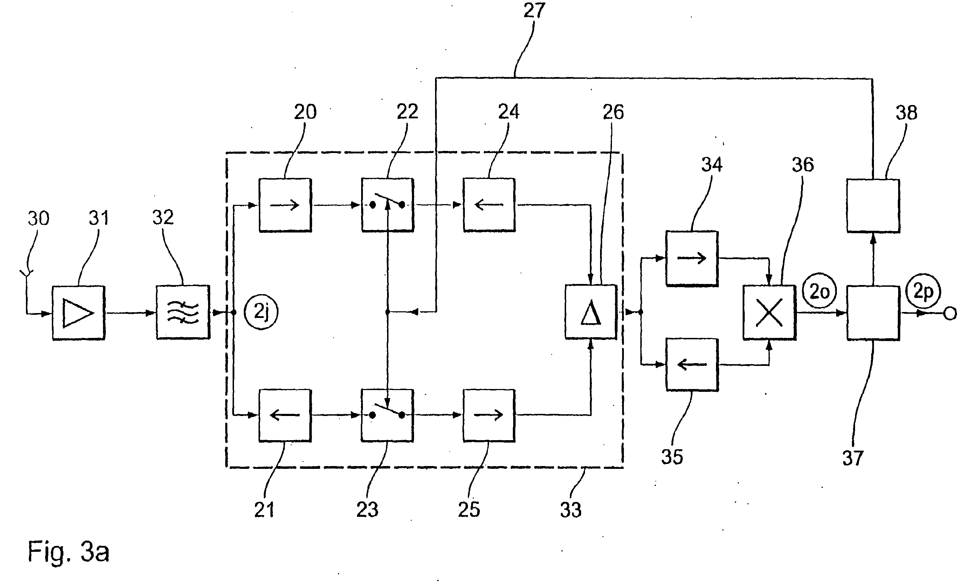

Der in der Figur 1a blockschaltbildartig dargestellte Sender zeigt ein Beispiel' der Erzeugung der Faltimpulse zur Übertragung eines in digitalisierter Form vorliegenden beispielsweise binären Signales über eine störungsbehaftete Übertragungsstrecke an einen in den Figuren 3a bis 3d dargestellten Empfänger, wobei die Übertragung bei vorgegebenen Anforderungen an Reichweite und Störsicherheit vorteilhaft mit einer relativ geringen Sendeleistung erfolgen kann. Bei einem batteriebetriebenen Sender wird dadurch die Batterielebensdauer erhöht, und vor allem die Umweltbelastung durch elektromagnetische Strahlung (EMI) - auch als Elektro-Smog bezeichnet - im Sinne der Human Exposure erniedrigt. Darüber hinaus weist der Sender aufgrund seiner relativ geringen Sendeleistung ein verringertes Störpotential gegenüber anderen Sende - Empfangsstrecken (EMC - Electro-Magnetic-Compability) verglichen mit anderen Nachrichtenübertragungssystemen auf.

Die kreisförmig umrandeten Bezugszeichen enthalten hierbei - wie auch in den folgenden Figuren verwendet - jeweils Verweise auf die Darstellung des zugehörigen Signalverlaufs in den entsprechenden Figuren.

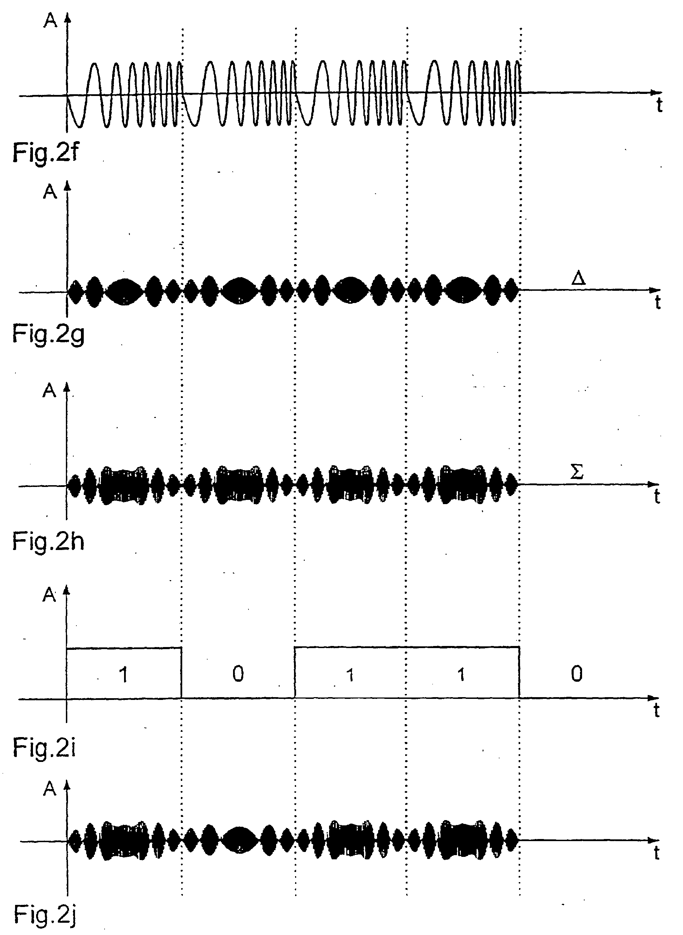

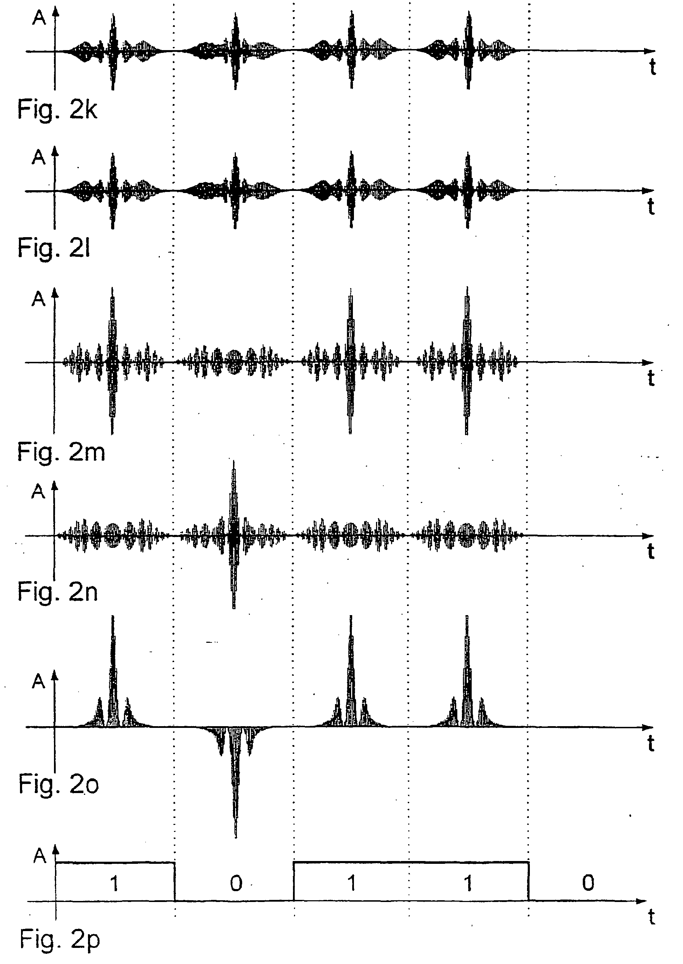

So zeigt die Figur 2i zum Beispiel den Signalverlauf des binären Eingangssignals. Die vorstehend erwähnte Übertragung mit einer relativ geringen Sendeleistung wird in dem dargestellten erfindungsgemäßen Übertragungssystem dadurch ermöglicht, daß senderseitig Faltimpulse erzeugt werden, die empfängerseitig - wie noch detailliert beschrieben werden wird - durch Dispersionsfilter zeitlich komprimiert werden, was zu einer entsprechenden Amplitudenerhöhung führt und durch zusätzliche korrelative Signalverarbeitung im analogen Bereich des Empfängers eine weitgehende Verbesserung des Signal/Rauschverhältnisses erlaubt und durch diese Eigenschaften zum Beispiel eine Reduktion der Sendeleistung oder alternativ eine Erhöhung der Reichweite ermöglicht.

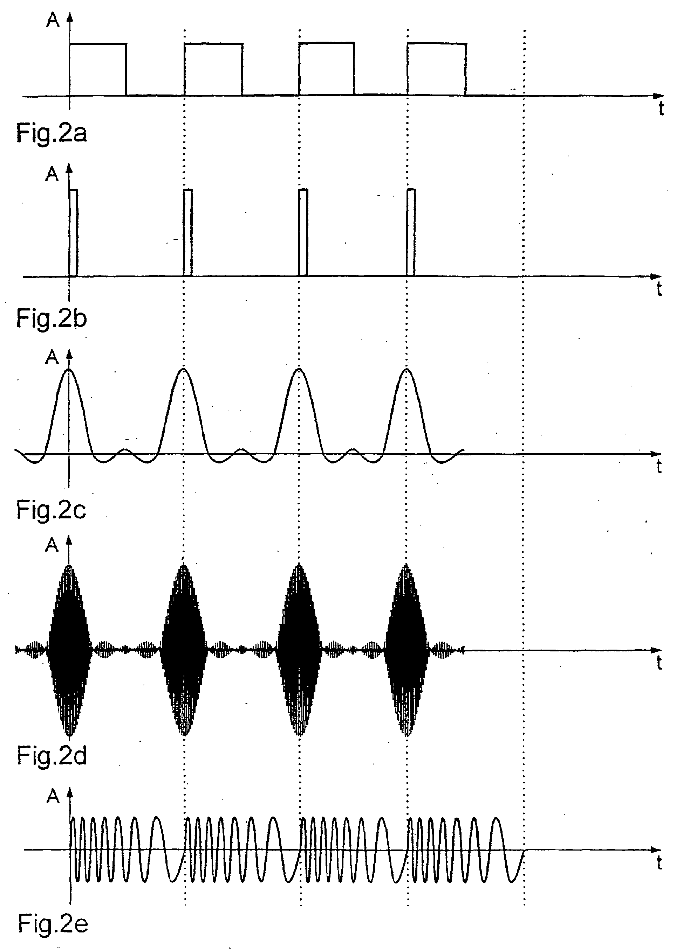

Zur Erzeugung der Faltimpulse weist der Sender zunächst einen Impulsgenerator 1 auf, der - wie in Figur 2a dargestellt, eine kontinuierliche Folge von äquidistanten Rechteckimpulsen erzeugt. Die von dem Impulsgenerator 1 erzeugte Impulsfolge dient hierbei jedoch lediglich der Erzeugung von Faltimpulsen und beinhaltet zunächst keine Informationen. Nachfolgend wird die von dem Impulsgenerator 1 erzeugte Rechteckimpulsfolge dem Impulsformer 2 zugeführt, der die Aufgabe hat, die einzelnen Rechteckimpulse jeweils in sehr kurze Stoßimpulse (Quasi-Dirac-Impulse) zu wandeln. Der Impulsformer 2 bildet die als mathematische Idealvorstellung nicht erreichbaren Dirac-Impulse hierbei durch kurze Nadelimpulse nach, wie in Figur 2b dargestellt.

Die auf diese Weise erzeugte Folge von Nadelimpulsen wird anschließend einem Tiefpaßfilter 3 zugeführt, dessen Filterkennlinie kurz vor der Grenzfrequenz eine Überhöhung aufweist und die die nadelförmigen Impulse in Spaltimpulse (si-Impulse) transformiert, wie dies detailliert in Figur 2c dargestellt ist.

Nachfolgend wird diese Impulsfolge mittels eines Amplitudenmodulators (Multiplikators) 4 auf eine von dem Oszillator 5 erzeugte hochfrequente Trägerschwingung mit der konstanten Trägerfrequenz $f_T$ aufmoduliert, um eine drahtlose Übertragung zu ermöglichen. Am Ausgang des Amplitudenmodulators 4 erscheint somit eine Folge von äquidistanten Trägerfrequenzimpulsen mit jeweils si-förmiger Hüllkurve, wie in Figur 2d dargestellt. Wichtig ist in diesem Zusammenhang, daß die am Ausgang des Amplitudenmodulators 4 erscheinende Impulsfolge unabhängig von dem in Figur 2i wiedergegebenen digitalen Eingangssignal ist und somit keine Information trägt.

Die auf eine Trägerfrequenz aufmodulierte Impulsfolge wird anschließend zwei parallel geschalteten Dispersionsfiltern 6, 7 zugeführt, die jeweils ein vorgegebenes frequenzabhängiges differentielles Laufzeitverhalten (Gruppenlaufzeitverhalten) aufweisen und - wie in den Figuren 2e und 2f dargestellt - winkelmodulierte Impulse erzeugen.

Die in den Figuren 2a bis 2n dargestellten Kurvenverläufe sind vor allem in der Zeitachse absichtlich nicht maßstabsgerecht gezeichnet, um den jeweiligen Kurvenverlauf und seinen Inhalt besser zu verdeutlichen. In Wirklichkeit sind die komprimierten Signale sehr viel schmaler und die Chirpsignalanteile sehr viel dichter auf der Zeitachse angeordnet.

Das Dispersionsfilter 6 weist hierbei eine mit der Frequenz zunehmende Gruppenlaufzeit auf und erzeugt somit- wie in Figur 2f dargestellt - winkelmodulierte Impulse mit einer während der Impulsdauer zunehmenden Frequenz. Die Frequenz am Ausgang des Dispersionsfilters 6 nimmt also zu Beginn des Impulses kontinuierlich und monoton von einem unterhalb der Trägerfrequenz $f_T$ liegenden Wert $f_T - \Delta f/2$ auf einen oberhalb der Trägerfrequenz $f_T$ liegenden Wert $f_T + \Delta f/2$ zu.

Die Gruppenlaufzeitcharakteristik des Dispersionsfilters 7 weist dagegen eine mit der Frequenz abnehmende Laufzeit auf, so daß am Ausgang des Dispersionsfilters 7 winkelmodulierte Impulse - wie in Figur 2e dargestellt - mit einer während der Impulsdauer abnehmenden Frequenz erscheinen.

Die Ausgangssignale der beiden Dispersionsfilter 6, 7 werden anschließend zur Erzeugung der Faltimpulse einem Addierer 8 sowie einem Subtrahierer 9 zugeführt, so daß zwei unterschiedliche Faltimpulse zur Informationsübertragung zur Verfügung stehen. Die Auswahl des zu übertragenden Faltimpulses erfolgt hierbei in Abhängigkeit von dem jeweiligen Wert des in Figur 2i wiedergegebenen binären Eingangssignals, das zur Bereitstellung definierter Signalpegel zunächst einem Bitdiskriminator 10 zugeführt wird und anschließend das Schalterelement 11 ansteuert. Bei einem HIGH-Pegel des Eingangssignals wird das von dem Addierer 8 erzeugte Summensignal ausgewählt, wohingegen ein LOW-Pegel des Eingangssignals zu einer Auswahl des Differenzsignals der beiden winkelmodulierten Impulse führt. Am Ausgang des Analogschalters 11 erscheint also, wie in Fig. 2j dargestellt, eine äquidistante Folge von unterschiedlichen Faltimpulsen entsprechend dem jeweiligen Wert des informationstragenden Eingangssignals.

Das am Ausgang des Analogschalters 11 erscheinende Signal wird anschließend von einem Bandpaßfilter 12 gefiltert, das auf die Trägerfrequenz $f_T$ des Oszillators 5 und auf die Bandbreite $\Delta f$ der Faltimpulskomponenten abgestimmt ist und somit außerhalb des Übertragungsbandes liegende Störsignale ausfiltert. Das auf diese Weise gewonnene Signal wird dann, wie üblich, von einem Sendeverstärker 13 verstärkt und über die Sendeantenne 14 abgestrahlt.

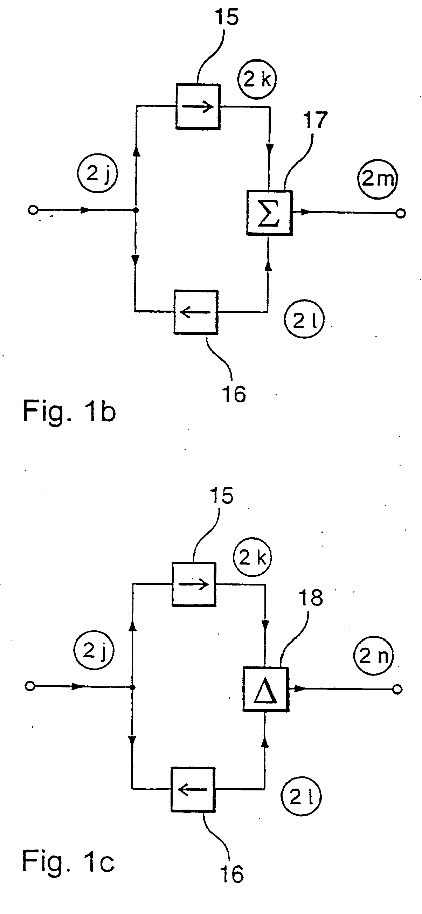

Die Figuren 1b bis 1f zeigen unterschiedliche Rauschunterdrückungsmodule für den Empfänger. Grundsätzlich können solche Rauschunterdrückungsmodule im analogen Teil eines Empfängers am Eingang des Empfängers hinter einem bandbegrenzenden Eingangsfilter, das hier nicht dargestellt ist, plaziert werden, oder sie könnten im ZF-Teil eines Empfängers untergebracht werden. Alle Rauschunterdrückungsmodule von Figur 1b bis 1f sind prinzipieller Natur und dienen zur Unterdrückung des Rauschens innerhalb von Faltimpulsen. Sie stellen also nur Funktionen dar und müssen durch entsprechende Schaltungen im HF- oder NF-Teil der Empfänger verwirklicht werden.

Figur 1b zeigt eine Additionsstufe. Der empfangene Faltimpuls 2j wird über ein Koppelelement parallel zwei Dispersionsfiltern 15 und 16 zugeführt. Das frequenzabhängige differentielle Laufzeitverhalten dieser Filter ist hierbei revers zuei-nander, wobei das positiv wirkende Dispersionsfilter eine differentielle Laufzeitcharakteristik aufweist, die eine parabolische Kennlinie zwischen der Frequenz und der differentiellen frequenzabhängigen Verzögerung aufweist. Hierzu sei die zugehörige Parabel von 15 nach oben offen. Das Dispersionsfilter 16 hat hierzu eine reverse Charakteristik, das heißt, ihr differentielles frequenzabhängiges Lauf zeitverhalten stellt eine nach unten offene Parabel dar. Man kann diese Kennlinien auch durch die Gruppenlaufzeit kennzeichnen, wobei komplementäre Gruppenlaufzeitkennlinien im Zeit- und Frequenzverhalten einmal einen positiven bzw. negativen (steigenden oder fallenden) Verlauf der Kennlinien aufweisen.

Die Pfeile in den Blockschaltungssymbolen 15 und 16, die in unterschiedliche Richtungen weisen, sollen den unterschiedlichen Charakter der Dispersionsfilter allgemein kennzeichnen, wobei die positive Pfeilrichtung hier ein sogenanntes "positives Dispersionsfilter" und der in negative Richtung zeigende Pfeil ein "negatives Dispersionsfilter" im Sinne der Beschreibungen darstellen soll.

Wie in der Beschreibung dargestellt, sind auch andere differentielle Laufzeitkennlinien möglich und auch erfordlich, wenn senderseitig Chirpsignalkomponenten anderer Winkelmodulationscharakteristik als Trägersubstrat aufmoduliert werden.

An den Ausgängen der beiden Dispersionsfilter 15 und 16 erscheint jeweils ein kombiniertes Signal, das aus einem zeitlich komprimierten Impuls mit entsprechend erhöhter Amplitude und überlagert hierzu aus einem zeitlich expandierten Impuls besteht. Die beiden Ausgangssignale 2k und 2l stellen zeitlich gleichartig verlaufende zur Mittellage des komprimierten Impulses symmetrische Signalverläufe dar. Die Ausgangssignale der Dispersionsfilter werden über eine Addierstufe 17 additiv überlagert. Das am Ausgang der Summierstufe erscheinende Signal zeigt einen reduzierten Rauschanteil im Verhältnis zum Signal, weil bei dem Signal die koinzidenten Amplituden addiert werden und beim Rauschen die in der Phasenlage und Amplitude statistisch auftretenden Werte nur bezüglich ihrer Leistung addiert werden. Das Ausgangssignal 2m weist also eine Signal/Rauschverbesserung auf.

Vorteilhaft ist es, durch einen Multiplexer am Eingang der Rauschunterdrückungsmodule den Signalweg auf zwei parallele Schaltungen nach Figur 1b aufzuteilen, der im Takt der Faltimpulsfolge (synchrcnisierbarer Betrieb) die einzelnen Falimpulse wechselnd einmal auf eines der Module und im Folgetakt auf das andere Modul schaltet. Durch die solchermaßen erfolgte Splittung werden die Rauschanteile auf die Dauer des Faltimpulses beschränkt und hierdurch wird der somit erzeugte überlagerte "Rauschimpuls" ebenfalls durch die dispersiven Filter gedehnt, was zu einer Reduzierung der Rauschanteile beiträgt.

Für Figur 1c gilt dieselbe Beschreibung wie für Figur 1b, wobei auch hier zwei parallel invers zueinander geschaltete Dispersionsfilter 15 und 16 das Faltsignal jeweils in einen komprimierten und expandierten Anteil verwandeln und diese beiden Signale über eine Differenzstufe subtrahiert werden. Da Addition und Subtraktion zueinander komplementäre Vorgänge darstellen, ist die Signal/Rauschverbesserung die gleiche wie für die Summation. Im übrigen gilt das gleiche wie das für Figur 1b Gesagte.

Da nach Figur 1a jedoch Summen- und Differenzsignale 2h und 2g generiert wurden, können hier die Summenstufe nach Figur 1b und die Differenzstufe nach Figur 1c die Summen- und Differenzsignale diskriminieren. Demzufolge kann man auch die Summenstufe 17 und die Differenzstufe 18 parallel schalten. Dann ist nur ein Dispersionsfilterpaar 15 und 16 erforderlich. Vorteilhafterweise geschieht dies auf einem einzigen SAW-Filter-Substrat. Die aus der Summen- und Differenzbildung hervorgehenden Signale 2m und 2n, die ein reduziertes Räuschen aufweisen, müssen dann im Empfängerzug entweder weiteren Verstärkern oder der Demodulation zugeführt werden.

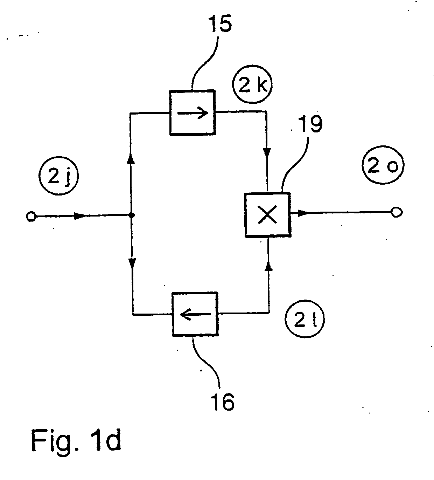

Figur 1d zeigt eine multiplikative Rauschreduktionsstufe für Faltsignale und stellt ebenfalls ein Modul dar, das innerhalb eines Verstärkerzuges verwendet werden kann. Das Faltsignal 2j wird hierbei auch zwei revers zueinander wirkenden Dispersionsfiltern 15 und 16 zugeführt, an deren jeweiligem Ausgang die kombinierten Signal 2k und 2l entstehen, in deren Mitte sich jeweils ein komprimierter Impuls befindet, wohingegen die expandierten Komponenten zueinander revers sind. Das Produkt dieser Multiplikation besteht aus einer Mischung der trägerfrequenten Signale 2k und 2l, die zur doppelten Trägerfrequenz führt. Da die Signale 2k und 2l in der Zeit- und Frequenzachse spiegelsymmetrisch gleich sind, werden die Signalamplituden, besonders deren komprimierter Anteil, quadriert. Da die Frequenzlage und die Frequenzanteile dieser miteinander multiplizierten Signale gleich sind, entstehen bei der Multiplikation die Summen und Differenzen der Frequenzen der miteinander multiplizierten kombinierten Signale. Die Spektren werden einmal zur doppelten Frequenz verschoben und zum anderen findet eine direkte phasenstarre kohärente Demodulation statt. Der Ausgang 2o zeigt also ein kombiniertes Signal mit doppelter Frequenzlage, gleichzeitig aber kann man einen Tiefpaß dem Ausgang nachschalten und erhält so direkt das demodulierte niederfrequente Signal. Diese Stufe, die man mit gewisser Berechtigung als autckorrelative Rauschunterdrükkungsschaltung bezeichnen kann, quadriert also die zeitlich zusammenfallenden Signale und unterdrückt das nichtkorrelierte Rauschen ähnlich wie bei der Autokorrelation periodischer oder quasi-periodischer Signale. Demnach führt dieses Modul nach Figur 1d vorteilhafterweise gleichzeitig drei analoge Prozesse durch, ohne daß ein synchronisierter Betrieb erforderlich wäre:

1. Wird das Faltsignal mit seinen revers zueinander symmetrisch liegenden Chirp-Signal-Komponenten durch die zueinander revers wirkenden Dispersionsfilter gleich zweimal komprimiert (Erhöhung der Signalamplitude).

2. Wird durch autokreuzkorrelative Multiplikation der koinzidenten Signalanteile das Signal gegenüber dem Rauschen hervorgehoben (korrelative Rauschunterdrückung).

3. Entsteht durch die Multiplikation ein kombiniertes Signal doppelter Frequenzlage im Vergleich zur ursprünglichen Trägerfrequenz und gleichzeitig das niederfrequente demodulierte Signal. (Produkt Demodulation). Von Verstärkern und Bandfiltern abgesehen, bewirkt also die Schaltung nach Figur 1d neben der automatischen Rauschunterdrückung und der automatischen Signalüberhöhung noch eine automatische Demodulation und repräsentiert damit sehr wichtige Funktionen eines Empfängers.

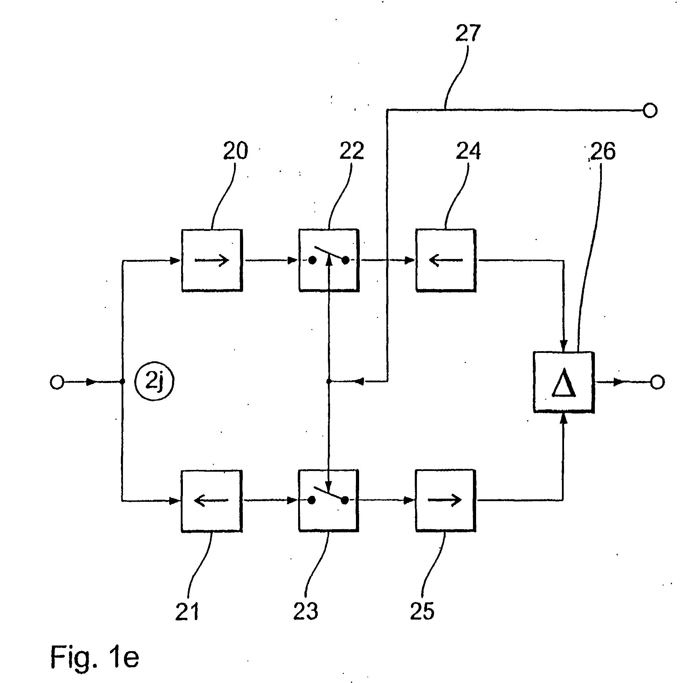

Figur 1e stellt wiederum ein Rauschunterdrückungsmodul anderer Art dar, das aber auch durch hervorragende Rauschunterdrückungseigenschaften gekennzeichnet ist. Speziell für das Faltsignal 2j am Eingang dieser Rauschunterdrückungsstufe ist diese Art von Rauschunterdrückung für synchronisierbare Datenübertragung sehr gut geeignet. Sie ist ebenfalls gekennzeichnet durch eine Aufsplittung des Signals über eine Gabel in zwei Signalzweige, deren oberer in der Figur eine Reihenschaltung eines positiven Dispersionsfilters 20, eines analogen Schalters 22 und eines negativen Dispersionsfilters 24 aufweist.

In dem in der Figur dargestellten unteren Zweig ist die gleiche Reihenschaltung aus einem negativen Dispersionsfilter 21, einem Analogschalter 23 und einem positiven Dispersionsfilter 25 dargestellt. Beide Zweige werden über eine Differenzstufe 26 einem Ausgang zugeführt. Die Schaltung ist am besten verständlich, wenn man sich die in der Mitte gelegenen Schalter 22 und 23 als zunächst geschlossen vorstellt. Bei dieser Konfiguration darf am Ausgang der Schaltung, also hinter der Differenzstufe 26, kein Signal erscheinen, weil die in den beiden Zweigen jeweils revers zueinander wirkenden Dispersionsfilter 20 und 24 beziehungsweise 21 und 25 wegen ihrer zueinander gegenläufigen Charakteristik die frequenzabhängigen Verschiebungen, die das jeweils erste Filter bewirkt, im zweiten wieder aufgehoben werden. Demzufolge müssen Signal- und Rauschanteile, die auf die Verzweigung gegeben werden, bei geschlossenen Schaltern am Ausgang der beiden Zweige nach 24 und 25 durch die Differenzstufe 26 sich aufheben, so daß am Ausgang weder Rauschen noch Signal erscheinen kann.

Da aber am Ausgang der beiden revers zueinander wirkenden Dispersionsfilter 20 und 21 genau wie in den vorher beschriebenen Anordnungen, zum Beispiel nach Figur 1d, spiegelsymmetrische koinzidente kombinierte Signale erzeugt werden, die jeweils aus einer komprimierten und einer expandierten Komponente bestehen, kann der Schalter durch ein Schaltsignal über den Eingang 27 so betätigt werden, daß er zum Beispiel während der kurzen Zeit der mittleren Dauer $\delta$ des komprimierten Signales dieses durch Unterbrechung des Signalweges in beiden Zweigen quasi herausschneidet und so dem kombinierten Signal in beiden Zweigen die jeweils komprimierte Komponente entnimmt, derart, daß die Signale in beiden Zweigen ungleich werden und jeweils nur aus ihren expandierten Komponenten zumindest annährerungsweise bestehen. Da aber die Faltsignale aufgrund ihrer zueinander reversen Chirpsignalkomponenten hinter dem ersten Paar der parallel geschalteten Dispersionsfilter 20 und 21 zueinander revers zur doppelten Dauer expandierte Chirpsignale erzeugen, werden durch den Schalter diese gedehnten Komponenten vergleichsweise kurzzeitig in deren zeitlicher Mitte unterbrochen, so daß am Ausgang der Schalter 22 und 23 auch jeweils zueinander reverse gedehnte Komponenten übrig bleiben, in deren Mitte ein vergleichsweise kurzes Stück durch die Unterbrechung ausgeschnitten wurde.

Da für diese gedehnten Anteile in beiden Zweigen die zeitliche Position der Frequenzanteile bestehen bleibt, werden diese beiden expandierten Signale in beiden Zweigen durch das zweite Dispersionsfilterpaar 24 und 25 wieder in die ursprüngliche Länge komprimiert. Demnach hebt.das Dispersionsfilter 24 die Expansion, die durch das Dispersionsfilter 20 im oberen Zweig bewirkt wurde, auf. Gleiches geschieht durch das Dispersionsfilter 25 für die Verschiebung durch das Filter 21 im unteren Zweig.

Da die mittlere Dauer des komprimierten Impulses $\delta$ je nach Kompressionsfaktor $\psi$ sehr viel kleiner ist als die doppelte Dauer des ursprünglichen Faltimpulses $\Delta t$, ist der Fehler, der beim Ausschneiden des komprimierten Impulses für die jeweils expandierten Signalanteile entsteht, relativ klein.

Am Ausgang der Dispersionsfilter 24 und 25 liegen also jetzt nach der Ausschneidetechnik zwei jeweils zueinander reverse Chirpimpulse vor, die bei der Differenzbildung wegen der gegenläufigen Frequenzen nicht sich aufheben können, einfach weil es ungleiche Signale sind.

Diese Rauschreduktionseinheit nach Figur 1e ist in mehrfacher Hinsicht theoretisch und praktisch interessant, weil sich einfach nachweisen läßt, daß bei immer größer werdendem Verhältnis $\Delta t/\delta = \psi$ der Fehler, der durch die Ausschneidetechnik begangen wird, immer kleiner wird oder, was das gleiche besagt, die Rauschreduktion immer besser wird.

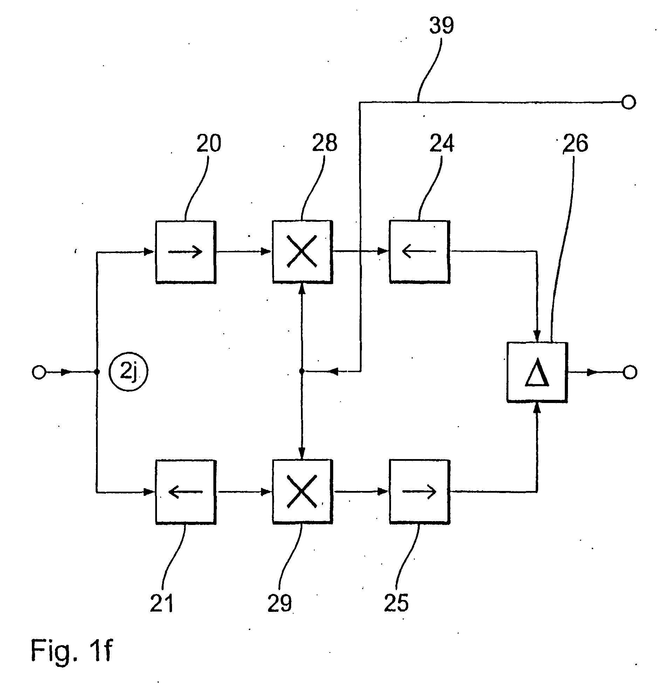

Für das Rauschen gilt also prinzipiell das gleiche wie für das Signal. In beiden Zweigen wird das Rauschen, das durch das Dispersionsfilter 20 entsprechend seiner spektralen Verteilung verschoben wird, durch das Dispersionsfilter 24, das revers zu 20 wirkt, bis auf den prozentual kleinen Mittelteil, der durch die Schalter unterbrochen wurde, rekombiniert. Gleiches gilt im unteren Zweig nach Figur 1 e. Demnach wird das Rauschen in beiden Zweigen bis auf den ausgeschnittenen Anteil, der energetisch klein ist, im oberen und unteren Zweig gleich sein und sich durch die Differenzstufe 26 herausheben. Das heißt also, je nach Kompressionsfaktor $\psi$ erscheint am Ausgang dieser Rauschunterdrükkungsschaltung nach Figur 1e wieder ein Faltimpuls, dem in der Mitte wenige Schwingungsanteile fehlen und dessen Rauschanteile, durch die Differenzbildung weitgehend unterdrückt werden.

Die solchermaßen im S/N-Verhältnis verbesserten Faltsignale können dann weitergegeben werden und zusätzlich zum Beispiel durch eine Schaltung nach Figur 1d nochmals autokorrelativ bearbeitet werden, wobei weitere Rauschanteile eliminiert werden.

Hier zeigt sich ein Vorteil dieser Rauschunterdrückungsmodule. Da sie auf physikalisch unterschiedlichen Effekten bezüglich der Elimination der Rauschanteile beruhen, lassen sie sich unabhängig voneinander auch kombinieren. Ähnliche Ergebnisse lassen sich auch erzeugen, wenn man das kombinierte Signal bei der Ausschneidetechnik nicht für die Dauer des komprimierten Impulses unterbricht, sondern umgekehrt, nur für diese Dauer $\delta$ die Schalter schließt, also den komprimierten Impuls selektiert, der dann durch die Dispersionsfilter wieder in beiden Zweigen zur ursprünglichen Länge expandiert wird. Hierbei bleibt der nur kurzzeitige Rauschanteil, der auf $\delta$ enfällt, zwar erhalten, aber er wird durch die Dispersionsfilter wieder auf die ursprüngliche Dauer expandiert; sein Energieanteil ist jedoch sehr viel kleiner ist als ursprünglich für die Zeit $2\Delta t$.

Figur 1f zeigt eine weitere Abwandlung der Schaltung nach Figur 1e. Hier sind lediglich die Schalter 22 und 23 in den Längszweigen durch Multiplikatoren 28 und 29 ersetzt. Da Schalter und Multiplikatoren ähnliche Wirkung erzielen können, ist es in der Schaltung nach 1f besonders vorteilhaft, das Ausschneiden nach Schaltung Figur 1e durch ein multiplikatives Unterdrücken nach Figur 1f zu ersetzen, weil dieses nach der Optimalfiltertheorie die geringste Verzerrung des gedehnten Impulses ermöglicht.

Da ihre prinzipielle Wirkungsweise die gleiche ist wie die der Figur 1 e, wird auf eine auführliche Beschreibung verzichtet. Wichtig jedoch ist, daß die synchronisierten Multiplikationsimpulse, die auf der Leitung 39 den beiden Multiplikatoren parallel zugeführt werden, praktisch Signale der Amplitude 1 sind, die synchron getaktet in der zeitlichen Mitte der Faltimpulse der kombinierten Signale am Eingang der Multiplikatoren gemäß dem Verlauf einer Spaltfunktion (si-Funktion) zu Null geschaltet werden, derart, daß sie eine Umkehrung der normierten Hüllkurve des komprimierten Signalanteiles des kombinierten Signales während der Zeit $\delta$ darstellen. Hierdurch unterdrücken sie multiplikativ eben diesen komprimierten Anteil. Die Unterdrückungssignale also stellen nichts anderes dar als eine invertierte si-Funktion, die zu Null geklemmt ist. Allerdings setzt diese Schaltung einen synchronen Betrieb voraus, der aber durchaus zur Demodulation einer Pulsfolge üblich ist.

Von Figur 1b bis 1f wurden Rauschunterdrückungskompor.enten beschrieben und dargestellt, die grundsätzlich unabhängig voneinander eingesetzt werden können, weil sie alle auf unterschiedlichen physikalischen Wirkungen auf das kombinierte Signal gekennzeichnet sind.

Figur 3a zeigt eine solche Kombination der Rauschunterdrükkungsmodule nach Figur 1e und Figur 1d. Das von der Antenne 30 kommende trägerfrequente Faltsignal kann durch einen Vorverstärker 31 verstärkt und über einen Bandpaßfilter 32 von außerhalb der Empfangsbandbreite liegenden Störern befreit werden. Das hochfrequente Faltsignal 2j wird dann in dem Rauschunterdrückungsmodul 33, das identisch bei der Figur 1e beschrieben wurde, in seinem Signal/Rauschverhältnis quasi passiv verbessert und darauf folgend durch die korrelative Stufe, wie sie in Figur 1d beschrieben wurde, von weiteren Rauschanteilen befreit und gleichzeitig durch multiplikative Demodulation 36 in das NF-Signal zurückverwandelt werden. Die nachfolgenden Schaltungsbestandteile entsprechen dem Stand der Technik. Danach kann zum Beispiel in 37 ein Tiefpaß zur Filterung des niederfrequenten Signales vorgesehen werden, ferner kann über eine Schwelle das Signal diskriminiert und in seiner Pulslänge geformt werden. Ferner sollen sich in 38 Synchronisationsstufen befinden, die die Schaltimpulse für die Schalter 22 und 23 derart generieren, daß ihre zeitliche Position genau in der Mitte der kombinierten Signale bezogen auf den Ausgang des Dispersionsfilters 20 beziehungsweise 21 zu liegen kommt..Die Dauer des Schaltimpulses kann vorteilhafterweise etwas kleiner sein als die mittlere Pulsdauer $\delta$ des komprimierten signales.

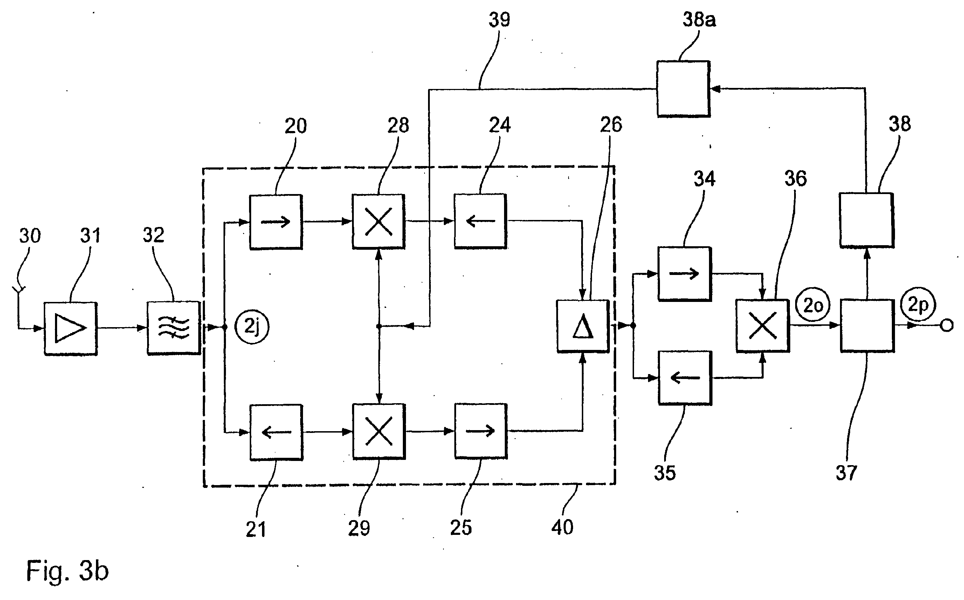

Die Beschreibung der Figur 3b ist funktionell identisch mit der Beschreibung für Figur 3a, sieht aber statt der Schalter 22 und 23 hier Multiplikatoren 28 und 29 vor, wobei über die Leitung 39 den Multiplikatoren, wie bei der Schaltung nach Figur 1f beschrieben, invertierte und zu Null geklemmte Spaltimpulse zugeführt werden. Die Form solcher Impulse kann je nach Störer optimiert werden.

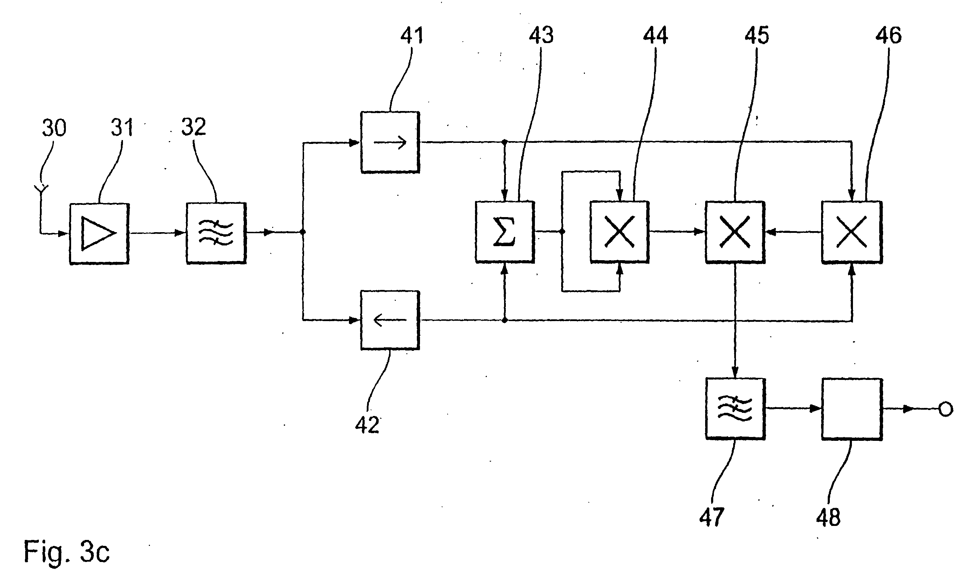

Figur 3c zeigt ebenfalls eine Empfängerschaltung in der zwei der Rauschunterdrückungsmodule nach Figur 1b und nach Figur 1d verwendet werden. Die Schaltung funktioniert wie folgt: Das trägerfrequente Signal an der Antenne 30 wird über einen Vorverstärker 31 und einen nachfolgenden Bandpaß für die Trägerfrequenzbandbreite geleitet. Am Ausgang dieses Bandpasses wird das Faltsignal verzweigt und wie bekannt über die zwei parallel geschalteten, revers zueinander wirkenden Dispersionsfilter 41, 42 geführt. Die Ausgänge der beiden Dispersionsfilter werden einmal auf eine Summierstufe 43 und parallel hierzu auf eine Multiplikationsstufe 46 geleitet, wobei die Additionsstufe so wirkt wie für Figur 1b und die Multiplikationsstufe so wie für Figur 1d beschrieben. Am Ausgang der Summierstufe 43 erscheint also ein Signal, dessen S/N-Verhältnis durch additive Korrelation verbessert ist.

Das Signal liegt im trägerfrequenten Bereich und wird auf die Quadrierstufe, die aus einem Multiplikator 44 besteht, gegeben, um an dessen Ausgang ein Signal zu erhalten, das in einem Trägerfrequenzbereich liegt, dessen Mittenfrequenz der doppelten Trägerfrequenz des ursprünglichen Faltsignales entspricht.

Gleichzeitig entsteht am Ausgang der Quadrierstufe nicht nur ein Signal mit doppelter Trägerfrequenz, sondern auch das niederfrequente Signal durch die quadratische Mischung. Der Ausgang des Multiplikators 46, der als autokorrelativer Multiplikator wirkt, enthält ebenfalls das trägerfrequente Signal mit doppelter Trägerfrequenz und gleichfalls das N/F-Signal. Multipliziert man diese beiden Ausgänge, den Ausgang des Multiplikators 46 mit dem Ausgang der Quadrierstufe 44 wiederum miteinander über die Multiplikationsstufe 45, werden die koinzidenten Signale im HF- und NF-Bereich wiederum korrelierend, also rauschunterdrückend multipliziert, da der Ausgang des Multiplikators 46 auch das quadrierte NF-Signal enthält, kann über einen Tiefpaß 47 und eine Pulsformerstufe 48 das ursprüngliche niederfrequente Signal, als zum Beispiel binäre Pulsfolge oder auch als PPM-Folge, je nach verwendeter Grundmodulationsart entnommen werden.

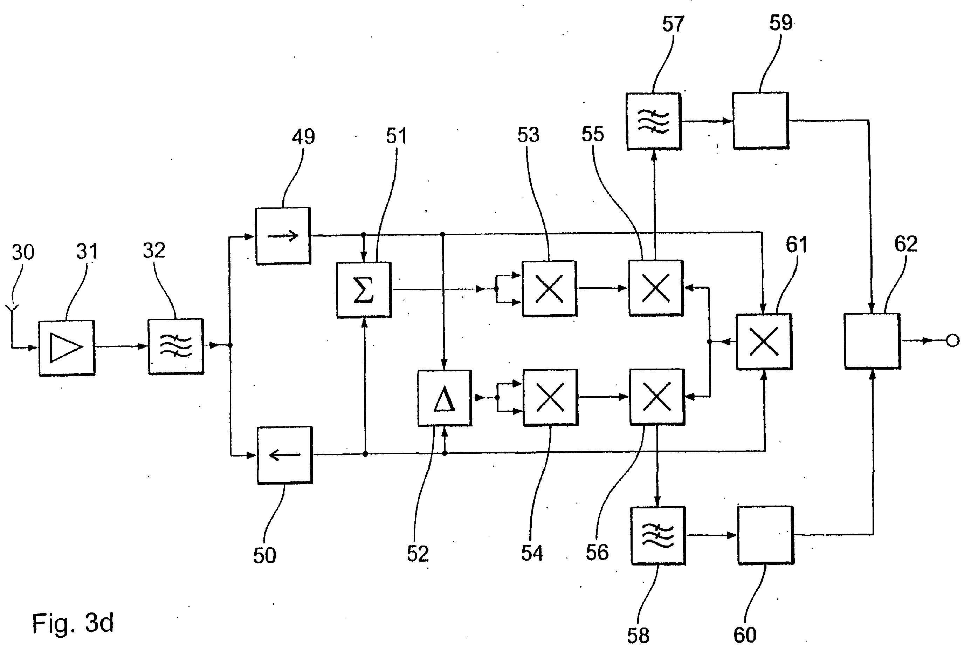

Figur 3d stellt eine Erweiterung der in Figur 3c verwendeten Prinzipien insofern dar, als hier die eben beschriebene Schaltung nach Figur 3c noch um eine differenzbildende Stufe 52 mit nachfolgender Quadrierstufe 54 und Multiplikator 56, Tiefpaß 58 und Pulsformerstufe 60 analog zu Figur 3c erweitert wurde. In Figur 3d also wird nicht nur die Summe der kombinierten Signale aus den Dispersionsfiltern 49 und 50 über die Summenstufe 51 genommen, sondern parallel hierzu die Differenz der kombinierten Signale über die Differenzstufe 52 und beide Signale, das aus der Summier- und das aus der Differenzstufe stammende, werden mehrfach multiplikativ analog zu den nach Figur 3c dargestellten Prinzipien demoduliert. Insofern stellt die Schaltung nach Figur 3d eine Möglichkeit dar, die Summen- und Differenzsignale, wie sie nach Figur 1a im Sender erzeugt wurden, im Empfänger nach Figur 1a getrennt zu demodulieren.

Um das Verständnis für die hier dargestellten vielfachen Möglichkeiten nochmals zu vertiefen, um eine klare Regel zum technischen Handeln zu geben und entsprechende Entscheidungen zu erleichtern, werden nachfolgend nochmals zusammenfassend die Grundgedanken und Möglichkeiten erläutert.

Die hier beispielhaft gemäß Figur 1a als Sender und Figur 3a, 3b, 3c und 3d als Empfänger dargestellten Blockschaltbilder sind aufgrund der generellen Aufgabenstellung nur prinzipieller Natur und zeigen Beispiele wie die unterschiedlichen Rauschunterdrückungsmodule gemäß Figur 1b, 1c, 1d, 1e und 1f als Bausteine zur Signalrauschverbesserung im Empfänger benutzt werden können und sie zeigen, wie bei der analogen Faltimpulssignalverarbeitung zwei parallel geschaltete zueinander inverse Dispersionsfilter mit anschließenden Summen-, Differenz-, Multiplizier- und Quadrierstufen für die spiegelsymmetrischen kombinierten Signale zur Rauschunterdrückung oder iterativen Rauschunterdrückung in verschiedensten Schaltungen zu mehr oder weniger aufwendigen Blöcken zusammengestellt werden können, wie sie je nach fachmännischem Dafürhalten kombiniert werden mögen. Sie bieten also als Bausteine eine Fülle von Möglichkeiten, Rauschunterdrückungsschaltungen mit wenig Aufwand, also kostengünstig, oder mit mehr Aufwand, dann aber auch effizienter, zur S/N-Verbesserung im analogen Teil eines Empfängers anwenden zu können. Mit den Rauschunterdrükkungsmodulen nach Figur 1e oder Figur 1f mit in den Längszweigen befindlichen Schaltern oder Multiplikatoren, die beide auf der Zeitachse bei synchronisierbarem Betrieb arbeiten, läßt sich je nach Kompressionsfaktor eine erhebliche Rauschunterdrückung erzielen. Auch diese Module lassen sich einzeln oder zusätzlich in solche Empfängerzüge einbauen. Während aber die automatisch wirkenden Module nach Figur 1b, 1c und 1d sich für Asynchron- oder Synchronbetrieb verwenden lassen, lassen sich die Module nach Figur 1e und 1f nur für einen synchronisierbaren Betrieb applizieren.

Das verfahrens- und fertigungstechnisch Interessante an allen Modulen ist, daß bei der Verwendung von SAW-Filtern sich auf einem Ultraschallsubstrat mehrere SAW-Filter als Multidispersionsfilter anordnen lassen, bei denen. Summen- und Differenzstufen im Ultraschallbereich entwickelt und gefertigt werden können. Durch entsprechende Anschlüsse lassen sich universell verwendbare SAW-Filtermodule bilden, bei denen man - je nach Applikation und Kombination - Rauschunterdrückungsschaltungen mit Silicon-Chips zusammenschalten kann, auf denen sich zum Beispiel Multiplikatoren oder Schalter befinden. Es ist dann dem Fachmann anheim gestellt, entsprechende Verschaltungen mehr oder weniger aufwendig und effektvoll vornehmen zu können.

Die Faltimpulse also bieten durch ihre speziellen mehrfachkorrelierbaren Eigenschaften durch symmetrische Systemstrategien recht preiswerte und effektvolle Möglichkeiten zur Entwicklung moderner Übertragungssysteme, die durch eine erhebliche Verbesserung des Signal/Rauschverhältnisses gekennzeichnet sind und die damit einen energiesparenden, sicheren Kommunikationsbetrieb zur Nachrichtenübertragung ermöglichen, und die außerdem dazu dienen können, die Human Exposure herabzusetzen.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

**Patentansprüche**

**1.** Verfahren zur Übertragung oder Speicherung einer einem Signal aufgeprägten Nachricht von einem Sender über eine Übertragungsstrecke zu einem Empfänger bei dem ein Eingangssignal in dem Sender einer Modulation unterworfen wird und über die Übertragungsstrecke zu dem Empfänger gelangt, wobei im Falle der Speicherung nachfolgend an die Stelle des Senders eine Schreibeinheit und an die Stelle des Empfängers eine Leseeinheit tritt, **dadurch gekennzeichnet,**

**daß** im Sender winkelmodulierte Impulse, nämlich Chirpsignale (2e, 2f) mit während der Impulsdauer zeitlich entgegengesetzt erfolgender Frequenzmodulation erzeugt werden, die mittels eines ersten Übertragungselements (8, 9) jeweils paarweise zu einem Faltimpuls (2g, 2h) überlagert werden, wobei die zu dem Empfänger übertragenen Faltimpulse (2g, 2h) eine nach einem Modulations- oder Codierungsverfahren aufgeprägte Information tragen,

**daß** die Faltimpulse (2g, 2h) im Empfänger durch zwei oder mehrere, paarweise parallel geschaltete Dispersionsfilter (34, 35, 41, 42, 49, 50) mit frequenzabhängiger Gruppenlaufzeitcharakteristik gefiltert werden, wobei die frequenzabhängige Gruppenlaufzeitcharakteristik der beiden Dispersionsfilter (34, 35, 41, 42, 49, 50) an die Frequenzmodulation jeweils eines der beiden in ihrer Überlagerung den Faltimpuls (2g, 2h) bildenden Chirpsignale derart angepaßt ist, daß am Ausgang der beiden Dispersionsfilter eines Paares (34, 35, 41, 42, 49, 50) jeweils ein kombiniertes Signal (2k, 2l) erscheint, das aus einem zeitlich komprimierten Impuls mit entsprechend erhöhter Amplitude und einem zeitlich expandierten Impuls mit entsprechend verringerter Amplitude besteht, und

**daß** die an den Ausgängen der beiden empfängerseitig vorgesehenen Dispersionfilter (34, 35, 41, 42, 49, 50) erscheinenden kombinierten Signale (2k, 2l) mittels eines zweiten Überlagerungselements (36, 43, 46, 51, 52, 61) zusammengeführt werden.

2. Verfahren nach Anspruch 1, **dadurch gekennzeichnet, daß** die Faltimpulse (2g, 2h) senderseitig von dem ersten Überlagerungselement (8, 9) durch Addition oder Subtraktion von Paaren winkelmodulierter Impulse 2e, 2f) mit zeitlich entgegengesetztem Verlauf erzeugt werden.

3. Verfahren nach Anspruch 2, **dadurch gekennzeichnet, daß** bei einer zu übertragenden binären Impulsfolge die Faltimpulse (2g, 2h) senderseitig jeweils in Abhängigkeit von dem binären Wert der aufzuprägenden Nachricht entweder durch Addition oder durch Subtraktion zweier zeitlich entgegengesetzt frequenzmodulierter Impulse (Figur 2e, 2f) erzeugt werden.

4. Verfahren nach einem der vorhergehenden Ansprüche, **dadurch gekennzeichnet, daß** die Ausgangssignale der beiden empfängerseitig vorgesehenen Dispersionsfilter (34, 35, 41, 42, 49, 50) von dem zweiten Überlagerungselement (36, 43, 46, 51, 52, 61) addiert, subtrahiert oder multipliziert werden.

5. Verfahren nach einem der vorhergehenden Ansprüche, **dadurch gekennzeichnet, daß** das Ausgangssignal des zweiten Überlagerungselements (43, 51, 52) zur Rauschunterdrückung den beiden Eingängen eines Multiplizierers (44, 53, 54) zugeführt wird.

6. Verfahren nach einem der vorhergehenden Ansprüche,
   **dadurch gekennzeichnet,**
   **daß** das empfangene Signal in zwei parallele Zweige aufgeteilt und in beiden Zweigen durch jeweils zwei in Reihe geschaltete Dispersionsfilter (20, 24 bzw. 21, 25) gefiltert wird, wobei die in Reihe geschalteten Dispersionsfilter (20, 24 bzw. 21, 25) ein zueinander inverses frequenzabhängiges Laufzeitverhalten aufweisen,
   **daß** der Signalfluß in den beiden Zweigen mittels jeweils eines zwischen den beiden Dispersionsfiltern (20, 24 bzw. 21, 25) angeordneten steuerbaren Schaltelements (22, 23) oder einen Multiplizierer (28, 29) zu einem vorgegebenen Zeitpunkt in der Mittes jedes Impulses unterbrochen oder freigeschaltet wird,
   **daß** die beiden Zweige ausgangsseitig durch einen Subtrahierer (26) zusammengeführt werden.

7. Sender- und Empfänger-Anordnung zur Durchführung eines Verfahrens nach einem der vorhergehenden Ansprüche,
   mit einem Sender zur Aufnahme und Übertragung eines informationstragenden Eingangssignals (2i) und einem Empfänger zur Rückgewinnung des Eingangssignals (2i),
   **dadurch gekennzeichnet,**
   **daß** der Sender zur Erzeugung von mindestens zwei zeitlich entgegengesetzt frequenzmodulierten Impulsen mindestens zwei Impulsgeneratoren (1 bis 5 und 6 bzw. 7) aufweist die ausgangsseitig zur Erzeugung eines Faltimpulses, (2g, 2h) aus jeweils zwei entgegengesetzt frequenzmodulierten Chirpimpulsen (2e, 2f) mit einem ersten Überlagerungselement (8, 9) verbunden sind,
   **daß** der Sender zur Aufprägung der in dem Eingangssignal enthaltenen Information auf die Faltimpulse einen Modulator (11) aufweist,
   **daß** der Empfänger zur Aufbereitung der empfangenen Faltimpulse (2g, 2h) zwei Dispersionsfilter (34, 35, 41, 42, 49, 50) mit frequenzabhängiger Laufzeitcharakteristik aufweist, wobei die frequenzabhängige Laufzeitcharakteristik der beiden Dispersionsfilter (34, 35, 41, 42, 49, 50) an die Frequenzmodulation jeweils eines der beiden in ihrer Überlagerung den Faltimpuls (2g, 2h) bildenden Chirpimpulse derart angepaßt ist, daß am Ausgang der beiden Dispersionsfilter (34, 35, 41, 42, 49, 50) jeweils ein kombiniertes Signal (2k, 2l) erscheint, das aus einem zeitlich komprimierten Impuls mit entsprechend erhöhter Amplitude und einem zeitlich expandierten Impuls mit entsprechend verringerter Amplitude besteht,
   **daß** den beiden empfängerseitig vorgesehenen Dispersionsfiltern (34, 35, 41, 42, 49, 50) ein zweites Überlagerungselement (36, 43, 46, 51, 52, 61) nachgeschaltet ist, welches die Ausgangssignale der beiden Dispersionsfilter (34, 35, 41, 42, 49, 50) zusammenführt.

8. Anordnung nach Anspruch 7, **dadurch gekennzeichnet, daß** die beiden senderseitigen Impulsgeneratoren (1 bis 5 und 6 bzw. 7) zur Erzeugung der entgegengesetzt frequenzmodulierten Impulse (2e, 2f) jeweils ein Dispersionsfilter (6, 7) mit frequenzabhängiger Laufzeitcharakteristik aufweisen, wobei das eine Dispersionsfilter (7) eine mit der Frequenz monoton abnehmende Laufzeit und das andere Dispersionsfilter (6) eine mit der Frequenz mononton zunehmende Laufzeit aufweist.

9. Anordnung nach Anspruch 7 oder 8, **dadurch gekennzeichnet, daß** das senderseitig zur Erzeugung der Faltimpulse (2g, 2h) vorgesehene erste Überlagerungselement (8, 9) ein Addierer (8) und/oder ein Subtrahierer (9) ist.

10. Anordnung nach Anspruch 9, **dadurch gekennzeichnet, daß** das informationstragende Eingangssignal eine binäre Impulsfolge ist und der senderseitig zur Aufprägung der in dem Eingangssignal (2i) enthaltenen Information vorgesehene Modulator ein durch das Eingangssignal steuerbares Schaltelement (11) ist, das zur Auswahl entweder der Summe oder der Differenz der beiden entgegengesetzt winkelmodulierten Impulse (2e, 2f) eingangsseitig mit dem Addierer (8) und dem Subtrahierer (9) verbunden ist.

11. Anordnung nach einem der Ansprüche 7 bis 10, **dadurch gekennzeichnet, daß** das empfängerseitig vorgesehene zweite Überlagerungselement ein Addierer (43, 51), ein Subtrahierer (52) oder ein Multiplizierer (36, 46, 61) ist.

12. Anordnung nach einem der Ansprüche 7 bis 11, **dadurch gekennzeichnet, daß** das empfängerseitig vorgesehene zweite Überlagerungselement (36, 43, 46, 51, 52, 61) zur Autokorrelation ausgangsseitig mit beiden Eingängen eines Multiplizierers (44, 53, 54) verbunden ist.

13. Anordnung nach einem der Ansprüche 7 bis 12, **dadurch gekennzeichnet, daß** der Empfänger eine Rauschunterdrückungsschaltung (33) aufweist, die im wesentlichen aus zwei parallel geschalteten Zweigen besteht, die ausgangsseitig mit den Eingängen eines Subtrahierers (26) verbunden sind und in denen jeweils zwei Dispersionsfilter (20, 24 bzw. 21, 25) mit zueinander inversen frequenzabhängigen Laufzeitcharakteristiken in Reihe geschaltet sind, wobei in jedem der beiden Zweige zwischen den beiden Dispersionsfiltern (20, 24 bzw. 21, 25) zur Unterdrückung oder Durchschaltung des Signalflusses ein analoges Schalterelement (22, 23) angeordnet ist, das im Takt der Synchronisation den Signalfluß durch Schaltsignale steuert, die nach Position und Dauer von einer digitalen Synchronisationseinheit (38) generiert werden.

14. Anordnung nach einem der Ansprüche 7 bis 12, **dadurch gekennzeichnet, daß** der Empfänger eine Rauschunterdrückungsschaltung (40) aufweist, die im wesentlichen aus zwei parallel geschalteten Zweigen besteht, die ausgangsseitig mit den Eingängen eines Subtrahierers (26) verbunden sind und in denen jeweils zwei Dispersionsfilter (20, 24 bzw. 21, 25) mit zueinander inversen frequenzabhängigen Laufzeitcharakteristiken in Reihe geschaltet sind, wobei in jedem der beiden Zweige zwischen den beiden Dispersionsfiltern (20, 24 bzw. 21, 25) zur Unterdrückung oder Durchschaltung des Signalflusses ein Multiplizierer (28, 29) angeordnet ist, der eingangsseitig mit dem vorgeschalteten Dispersionsfilter (20, 21) und einem analogen Signalgenerator (38a) verbunden ist, der angesteuert wird durch die digitale Synchronisationseinheit 38 und im Takt der Synchronisation zur Multiplikation Signale erzeugt, die einen von einem Rechtecksignal abweichenden Kurvenverlauf aufweisen, der geeignet ist, Teile des Signalverlaufs multiplikativ zu unterdrücken oder freizuschalten.

15. Anordnung nach einem der Ansprüche 7 bis 14, **dadurch gekennzeichnet, daß** zur Rauschunterdrückung im Empfänger eine Rauschunterdrückungsschaltung vorgesehen ist, die zur Aufteilung des empfängerseitigen Signalflusses zwei parallel geschaltete Zweige aufweist, in denen jeweils ein Dispersionsfilter (15, 16) mit einer frequenzabhängigen Laufzeitcharakteristik angeordnet ist, wobei das eine Dispersionsfilter (15) eine mit der Frequenz monoton abnehmende Laufzeit und das andere Dispersionsfilter (16) eine mit der Frequenz mononton zunehmende Laufzeit aufweist und die beiden Dispersionsfilter (15, 16) ausgangsseitig mit den Eingängen eines Addierers (17) oder eines Subtrahierers (18) oder eines Multiplizierers (19) verbunden sind.

16. Senderanordnung zur Durchführung der senderzeitigen Verfahrensschritte eines Verfahrens nach einem der Ansprüche 1 bis 6,
mit einem Sender zur Aufnahme und Übertragung eines informationstragenden Eingangssignals (2i),
**dadurch gekennzeichnet,**
**daß** der Sender zur Erzeugung von mindestens zwei zeitlich entgegengesetzt frequenzmodulierten Chirp-Impulsen (2e, 2f) mindestens zwei Impulsgeneratoren (1 bis 5 und 6 bzw. 7) aufweist, die ausgangsseitig zur Erzeugung eines Faltimpulses (2g, 2h) aus jeweils zwei entgegengesetzt frequenzmodulierten Chirpimpulsen (2e, 2f) mit einem ersten Überlagerungselement (8, 9) verbunden sind, und
**daß** der Sender zur Aufprägung der in dem Eingangssignal (2i) enthaltenen Information auf die Faltimpulse (2g, 2h) einen Modulator (11) aufweist.

17. Empfängeranordnung zur Durchführung der empfängerseitigen Verfahrensschritte eines Verfahrens nach einem der Ansprüche 1 bis 6.
mit einem Empfänger zur Rückgewinnung eines informationstragenden Eingangssignals (2i)
**dadurch gekennzeichnet,**

**daß** der Empfänger zur Aufbereitung der empfangenen Faltimpulse (2g, 2h) zwei Dispersionsfilter (34, 35, 41, 42, 49, 50) mit frequenzabhängiger Laufzeitcharakteristik aufweist, wobei die frequenzabhängige Laufzeitcharakteristik der beiden Dispersionsfilter (34, 35, 41, 42, 49, 50) an die Frequenzmodulation jeweils eines der beiden in ihrer Überlagerung den Faltimpuls (2g, 2h) bildenden Impulse (2e, 2f) derart angepaßt ist, daß am Ausgang der beiden Dispersionsfilter (34, 35, 41, 42, 49, 50) jeweils ein kombiniertes Signal (2k, 2l) erscheint, das aus einem zeitlich komprimierten Impuls mit entsprechend erhöhter Amplitude und einem zeitlich expandierten Impuls mit entsprechend verringerter Amplitude besteht,

und **daß** den beiden empfängerseitig vorgesehenen Dispersionsfiltern (34, 35, 41, 42, 49, 50) ein zweites Überlagerungselement (36, 43, 46, 51, 52, 61) nachgeschaltet ist, welches die Ausgangssignale der beiden Dispersionsfilter (34, 35, 41, 42, 49, 50) zusammenführt.

### Claims

1.  Method for the transmission or storage of an impressed communication signal from a transmitter to a receiver via a transmission section, in which an input signal in the transmitter is subjected to a modulation and arrives at the receiver via the transmission section, whereby in the case of storage a writing unit takes the place of the transmitter and a reading unit takes the place of the receiver, **characterised in that** angle modulated pulses, i.e. chirp signals (2e, 2f), are produced in the transmitter with temporally opposite frequency modulation occurring during the duration of the pulse, the pairs of pulses being superimposed by a first superimposing element (8, 9) into a folded pulse (2g, 2h), whereby the folded pulses (2g, 2h) transmitted to the receiver carry a communication impressed upon them after a modulation or encoding process,

    **in that** the folded pulses (2g, 2h) are filtered in the receiver by two or more dispersion filters (34, 35, 41, 42, 49, 50) connected in parallel in pairs with frequency-dependent group delay characteristics, whereby the frequency-dependent group delay characteristic of both dispersion filters (34, 35, 41, 42, 49, 50) is matched to the frequency modulation in one of the two chirp signals forming the folded pulse (2g, 2h) in their superposition, so that at the output of the two dispersion filters of a pair (34, 35, 41, 42, 49, 50) a combined signal (2k, 2l) appears that consists of a time-compressed pulse with a correspondingly increased amplitude and a time-expanded pulse with a correspondingly diminished amplitude and **in that** the combined signals (2k, 2l) appearing at the outputs of both dispersion filters (34, 35, 41, 42, 49, 50) on the receiver side are combined by a second superimposing element (36, 43, 46, 51, 52, 61).

2.  Method according to claim 1, **characterised in that** the folded pulses (2g, 2h) are generated on the transmitter side by the first superimposing element (8, 9) by the addition or subtraction of pairs of angle-modulated pulses (2e, 2f) in reverse chronological order.

3.  Method according to claim 2, **characterised in that** with a binary pulse sequence to be transmitted, the folded pulses (2g, 2h) are generated on the transmitter side in dependence of the binary value of the communication to be impressed, either by addition or subtraction of two frequency modulated pulses (Figure 2e, 2f) occurring in reverse chronological order.

4.  Method according to one of the preceding claims, **characterised in that** the output signals of the two receiver side dispersion filters (34, 35, 41, 42, 49, 50) are added, subtracted or multiplied by the second superimposing element (36, 43, 46, 51, 52, 61).

5.  Method according to one of the preceding claims, **characterised in that** the output signal of the second superimposing element (43, 51, 52) is supplied to two inputs of a multiplier (44, 53, 54) for noise suppression.

6.  Method according to one of the preceding claims **characterised in that** the received signal is divided into two parallel branches and is filtered in the two branches respectively by two series-connected dispersion filters (20, 24 or 21, 25), whereby the series-connected dispersion filters (20, 24 or 21, 25) display a inverse frequency-dependent time delay behaviour relative to one another, **in that** the signal flow in the two branches is interrupted or cleared in the middle of each pulse at a predetermined point in time by a controllable switching element (22, 23) or a multiplier (28, 29) arranged between the two dispersion filters (20, 24 or 21, 25), **in that** the two branches are brought together at the output end by a subtracter (26).

7.  Transmitting and receiving arrangement for performing a method according to one of the preceding claims with a transmitter for receiving and transmitting a communication-bearing input signal (2i) and a receiver for recovery of the input signal (2i), **characterised in that** for generating at least two frequency-modulated pulses occurring in reverse chronological order the transmitter has at least two pulse generators (1 to 5 and 6 or 7) which are connected on the output side with a first superimposing element (8, 9) for the generation of a folded pulse (2g, 2h) consisting of two opposed frequency-modulated chirp pulses (2e, 2f), **in that** the transmitter has a modulator (11) for impressing the information contained in the input signal onto the folded pulses, **in that** the receiver has two dispersion filters (34, 35, 41, 42, 49, 50) with frequency-dependent time delay characteristics, whereby the frequency-dependent delay characteristics of both dispersion filters (34, 35, 41, 42, 49, 50) is matched to the frequency modulation of one of the two chirp pulses forming the folded pulse (2g, 2h) by superposition, so that at the output of both dispersion filters (34, 35, 41, 42, 49, 50) a combined signal (2k, 2l) appears which consists of a time-compressed pulse with a correspondingly increased amplitude and a time-expanded pulse with a correspondingly diminished amplitude, **in that** a second superimposing element (36, 43, 46, 51, 52, 61) is connected downstream from the two receiver side dispersion filters (34, 35, 41, 42, 49, 50) which brings together the output signals of the two dispersion filters (34, 35, 41, 42, 49, 50).

8. Arrangement according to claim 7, **characterised in that** the two transmitter-side pulse generators (1 to 5 and 6 or 7) for the generation of opposed frequency-modulated pulses (2e, 2f) each have a dispersion filter (6, 7) with frequency-dependent delay characteristics, whereby one dispersion filter (7) has a transmit time that decreases monotonically with frequency and the other dispersion filter (6) has a transit time that increases monotonically with frequency.

9. Arrangement according to claim 7 or 8, **characterised in that** the first superimposing element (8, 9) provided on the transmitter side for producing the folded pulses (2g, 2h) is an adder (8) and/or a subtracter (9).

10. Arrangement according to claim 9, **characterised in that** the information-carrying input signal is a binary pulse sequence and the modulator provided on the transmitter side for impressing information contained in the input signal (2i) is a switching element (11) controllable by means of the input signal which is connected on the input side to the adder (8) and the subtracter (9) for selecting either the sum or the difference of the two oppositely angle-modulated pulses (2e, 2f).

11. Arrangement according to one of claims 7 to 10, **characterised in that** the second superimposing element provided on the receiver side is an adder (43, 51), a subtracter (52) or a multiplier (36, 46, 61).

12. Arrangement according to one of claims 7 to 11, **characterised in that** the second superimposing element (36, 43, 46, 51, 52, 61) provided on the receiver side is connected on the output side to both inputs of a multiplier (44, 53, 54) for autocorrelation.

13. Arrangement according to one of claims 7 to 12, **characterised in that** the receiver comprises a noise suppression circuit, that consists essentially of two parallel-connected branches which are connected on the output side to the inputs of a subtracter (26) and in which two dispersion filters (20, 24 or 21, 25) with frequency-dependent delay characteristics that are inverse to one other are connected in series, whereby in each of the two branches an analogue switching element (22, 23) is connected between the two dispersion filters (20, 24 or 21, 25) for suppression or switching through of a signal flow, the analogue element controlling signal flow in the cycle of synchronization through switching signals that are generated by a digital synchronization unit (38) according to position and duration.

14. Arrangement according to one of claims 7 to 12, **characterised in that** the receiver comprises a noise-suppression circuit (40) that consists essentially of two parallel-connected branches which are connected on the output side to the inputs of a subtracter (26) and in which two dispersion filters (20, 24, or 21, 25), with frequency-dependent delay characteristics that are inverse to each other, are connected in series, whereby in each of the two branches a multiplier (28, 29) is connected between the two dispersion filters (20, 24 or 21, 25) for suppression or switching through of the signal flow, which multiplier is connected on the input side with the upstream dispersion filter (20, 21) and an analogue signal generator (38a), which is controlled by the digital synchronization unit (38) and generates signals in the cycle of synchronization for multiplication, the signals displaying a profile, deviating from a rectangular signal, which is suitable for suppression or release of portions of the signal course through multiplication.

15. Arrangement according to one of claims 7 to 14, **characterised in that** for noise suppression in the receiver a noise-suppression circuit is provided which to divide the signal flow on the receiver side includes two parallel-connected branches, in which a dispersion filter (15, 16) is arranged respectively with a frequency-dependent delay characteristic whereby one dispersion filter (15) displays a delay time that decreases monotonically with frequency and another dispersion filter (16) displays a delay time that increases monotonically with frequency and the two dispersion filters (15, 16) on the output side are connected with the inputs of an adder (17) or of a subtracter (18) or of a multiplier (19).

16. Transmitter arrangement for performing the transmitter-side method steps of a method according to one of claims 1 to 6, with a transmitter for receiving and transmitting an information-bearing input signal (2i), **characterised in that** the transmitter to generate at least two time inverse frequency-modulated chirp pulses (2e, 2f) comprises at least two pulse generators (1 to 5 and 6 or 7), which on the output side are connected to produce a folded pulse (2g, 2h) of two inverse frequency-modulated chirp pulses (2e, 2f) with a first superimposing element (8, 9), and **in that** the transmitter has a modulator (11) to impress the information contained in the input signal (2i) on the fold pulses (2g, 2h).

17. Receiver arrangement for performing the receiver-side method steps of a method according to one of claims 1 to 6 with a receiver for recovering an information-carrying input signal (2i), **characterised in that** the receiver for preparing the received fold pulses (2g, 2h) has two dispersion filters (34, 35, 41, 42, 49, 50) with frequency-dependent delay characteristics, whereby the frequency-dependent delay characteristics of the two dispersion filters (34, 35, 41, 42, 49, 50) is adjusted to the frequency modulation of one of the two pulses (2e, 2f) forming in their superposition the fold pulse (2g, 2h), so that at the output of the two dispersion filters (34, 35, 41, 42, 49, 50) a combined signal (2k, 2l) appears which comprises a time-compressed pulse with suitably increased amplitude and a time-expanded pulse with suitably reduced amplitude, and **in that** after the two receiver-side dispersion filters (34, 35, 41, 42, 49, 50) a second superimposing element (36, 43, 46, 51, 52, 61) is connected which brings together the output signals of the two dispersion filters (34, 35, 41, 42, 49, 50).

**Revendications**

1. Procédé de transmission ou de stockage d'un message appliqué à un signal, à partir d'un émetteur à travers une voie de transmission jusqu'à un récepteur, dans lequel un signal d'entrée est soumis à une modulation dans l'émetteur et atteint le récepteur à travers la voie de transmission, une unité d'écriture prenant ensuite la place de l'émetteur et une unité de lecture la place du récepteur en cas de stockage,
   **caractérisé en ce que**
   dans l'émetteur, des impulsions à modulation angulaire, à savoir des signaux à compression d'impulsions (2e, 2f) sont produites pendant la durée d'impulsion par une modulation de fréquence effectuée de façon opposée dans le temps, ces impulsions, au moyen d'un premier élément de transmission (8, 9), étant superposées respectivement par paires en une impulsion repliée (2g, 2h), les impulsions repliées (2g, 2h) transmises au récepteur transportant une information appliquée selon un procédé de modulation ou de codage,
   **en ce que** les impulsions repliées (2g, 2h) sont filtrées dans le récepteur par deux ou plusieurs filtres de dispersion (34, 35, 41, 42, 49, 50) connectés par paires en parallèle et ayant une caractéristique de temps de propagation de groupe sélective, la caractéristique de temps de propagation de groupe sélective des deux filtres de dispersion (34, 35, 41, 42, 49, 50) étant adaptée à la modulation de fréquence respectivement d'un des deux signaux à compression d'impulsions constituant par leur superposition l'impulsion repliée (2g, 2h), de telle sorte qu'à la sortie des deux filtres de dispersion d'une paire (34, 35, 41, 42, 49, 50), respectivement un signal combiné (2k, 2l) apparaît qui se compose d'une impulsion comprimée dans le temps avec une amplitude accrue de façon correspondante et une impulsion étendue dans le temps avec une amplitude réduite de façon correspondante, et
   **en ce que** les signaux combinés (2k, 2l) apparaissant aux sorties des deux filtres de dispersion (34, 35, 41, 42, 49, 50) prévus côté récepteur sont regroupés au moyen d'un deuxième élément de superposition (36, 43, 46, 51, 52, 61).

2. Procédé selon la revendication 1, **caractérisé en ce que** les impulsions repliées (2g, 2h) sont produites côté émetteur par le premier élément de superposition (8, 9) par addition ou soustraction de paires d'impulsions à modulation angulaire (2e, 2f) avec un gradient opposé dans le temps.

3. Procédé selon la revendication 2, **caractérisé en ce que** dans une série d'impulsions binaires à transmettre, les impulsions repliées (2g, 2h) sont produites côté émetteur respectivement en fonction de la valeur binaire du message à appliquer, soit par addition, soit par soustraction de deux impulsions à modulation de fréquence opposées dans le temps (2e, 2f).

4. Procédé selon l'une quelconque des revendications précédentes, **caractérisé en ce que** les signaux de sortie des.deux filtres de dispersion (34, 35, 41, 42, 49, 50) prévus côté récepteur sont additionnés, soustraits ou multipliés par le deuxième élément de superposition (36, 43, 46, 51, 52, 61).

**5.** Procédé selon l'une quelconque des revendications précédentes, **caractérisé en ce que** le signal de sortie du deuxième élément de superposition (43, 51, 52) est amené aux deux entrées d'un multiplicateur (44, 53, 54) pour l'élimination de bruit.

**6.** Procédé selon l'une quelconque des revendications précédentes, **caractérisé en ce que**
le signal reçu est divisé en deux branches parallèles et est filtré dans les deux branches respectivement par deux filtres de dispersion (20, 24 ou 21, 25) connectés en série, les filtres de dispersion (20, 24 ou 21, 25) connectés en série présentant un comportement de temps de propagation sélectif mutuellement inverse,
**en ce que** le flux de signaux dans les deux branches est interrompu ou libéré au moyen respectivement d'un élément de commutation (22, 23) réglable disposé entre les deux filtres de dispersion (20, 24 ou 21, 25) ou d'un multiplicateur (28, 29) à un instant prédéterminé au milieu de chaque impulsion,
**en ce que** les deux branches sont regroupées côté sortie par un soustracteur (26).

**7.** Dispositif émetteur et récepteur pour exécuter le procédé selon l'une quelconque des revendications précédentes, comprenant un émetteur pour recevoir et transmettre un signal d'entrée (2i) transportant des informations et un récepteur pour récupérer le signal d'entrée (2i),
**caractérisé en ce que**
pour la génération d'au moins deux impulsions à modulation de fréquence opposée dans le temps, l'émetteur présente au moins deux générateurs d'impulsions (1 à 5 et 6 ou 7) qui sont reliés côté sortie à un premier élément de superposition (8, 9) pour générer une impulsion repliée (2g, 2h) respectivement à partir de deux impulsions à compression à modulation de fréquence opposées (2e, 2f),
**en ce que** l'émetteur présente un modulateur (11) pour appliquer aux impulsions repliées les informations contenues dans le signal d'entrée,
**en ce que** le récepteur présente deux filtres de dispersion (34, 35, 41, 42, 49, 50) avec une caractéristique de temps de propagation sélective pour la mise en forme des impulsions repliées (2g, 2h) reçues, la caractéristique de temps de propagation sélective des deux filtres de dispersion (34, 35, 41, 42, 49, 50) étant adaptée à la modulation de fréquence respectivement d'une des impulsions à compression constituant par leur superposition l'impulsion repliée (2g, 2h), de telle sorte qu'à la sortie des deux filtres de dispersion (34, 35, 41, 42, 49, 50), apparaît respectivement un signal combiné (2k, 2l) qui se compose d'une impulsion comprimée dans le temps avec une amplitude accrue de façon correspondante et une impulsion étendue dans le temps avec une amplitude réduite de façon correspondante, et
**en ce qu'**à la suite des deux filtres de dispersion (34, 35, 41, 42, 49, 50) prévus côté récepteur, un deuxième élément de superposition (36, 43, 46, 51, 52, 61) est placé qui regroupe les signaux de sortie des deux filtres de dispersion (34, 35, 41, 42, 49, 50).

**8.** Dispositif selon la revendication 7, **caractérisé en ce que** les deux générateurs d'impulsions côté émetteur (1 à 5 et 6 ou 7) pour la génération des impulsions à modulation de fréquence (2e, 2f) opposée présentent respectivement un filtre de dispersion (6, 7) avec une caractéristique de temps de propagation sélective, l'un des filtres de dispersion (7) présentant un temps de propagation diminuant de façon monotone avec la fréquence et l'autre filtre de dispersion (6) présentant un temps de propagation augmentant de façon monotone avec la fréquence.

**9.** Dispositif selon la revendication 7 ou 8, **caractérisé en ce que** le premier élément de superposition (8, 9) prévu côté émetteur pour générer les impulsions repliées (2g, 2h) est un additionneur (8) et/ou un soustracteur (9).

**10.** Dispositif selon la revendication 9, **caractérisé en ce que** le signal d'entrée transportant des informations est une série d'impulsions binaires et le modulateur prévu côté émetteur pour appliquer les informations contenues dans le signal d'entrée (2i) est un élément de commutation (11) réglable par le signal d'entrée, qui est relié côté entrée à l'additionneur (8) et au soustracteur (9) pour sélectionner soit la somme soit la différence des deux impulsions à modulation angulaire (2e, 2f) opposée.

**11.** Dispositif selon l'une quelconque des revendications 7 à 10, **caractérisé en ce que** le deuxième élément de superposition prévu côté récepteur est un additionneur (43, 51), un soustracteur (52) ou un multiplicateur (36, 46, 61).

**12.** Dispositif selon l'une quelconque des revendications 7 à 11, **caractérisé en ce que** le deuxième élément de superposition (36, 43, 46, 51, 52, 61) prévu côté récepteur est relié côté sortie aux deux entrées d'un multiplicateur (44, 53, 54) pour une autocorrélation.

**13.** Dispositif selon l'une quelconque des revendications 7 à 12, **caractérisé en ce que** le récepteur présente un circuit d'élimination de bruit qui se compose essentiellement de deux branches connectées en parallèle qui sont reliées côté sortie aux entrées d'un soustracteur (26) et dans lesquelles respectivement deux filtres de dispersion (20, 24 ou 21, 25) sont connectés en série avec des caractéristiques de temps de propagation sélectives mutuellement inverses, dans chacune des deux branches un élément de commutation analogique (22, 23) étant disposé entre les deux filtres de dispersion (20, 24 ou 21, 25) pour éliminer ou mettre en communication le flux de signaux, l'élément de commutation réglant le flux de signaux en cadence avec la synchronisation par des signaux de commutation qui sont générés selon la position et la durée d'une unité de synchronisation numérique (38).

**14.** Dispositif selon l'une quelconque des revendications 7 à 12, **caractérisé en ce que** le récepteur présente un circuit d'élimination de bruit qui se compose essentiellement de deux branches connectées en parallèle, qui sont reliées côté sortie aux entrées d'un soustracteur (26), et dans lesquelles respectivement deux filtres de dispersion (20, 24 ou 21, 25) avec des caractéristiques de temps de propagation sélectives mutuellement inverses sont connectés en série, dans chacune des deux branches, un multiplicateur (28, 29) étant disposé entre les deux filtres de dispersion (20, 24 ou 21, 25) pour éliminer ou mettre en communication le flux de signaux, le multiplicateur étant relié côté entrée au filtre de dispersion placé en amont (20, 21) et à un générateur de signal analogique (38a) qui est excité par l'unité de synchronisation numérique (38) et génère en cadence avec la synchronisation des signaux pour la multiplication qui présentent une forme de courbe différente d'un signal rectangulaire qui est adaptée pour éliminer ou déconnecter des parties de la forme de signal par multiplication.

**15.** Dispositif selon l'une quelconque des revendications 7 à 14, **caractérisé en ce qu'**un circuit d'élimination de bruit est prévu pour éliminer le bruit dans le récepteur, ce circuit présentant pour la séparation du flux de signaux côté récepteur deux branches connectées en parallèle dans lesquelles respectivement un filtre de dispersion (15, 16) est disposé avec une caractéristique de temps de propagation sélective, l'un des filtres de dispersion (15) présentant un temps de propagation diminuant de façon monotone avec la fréquence et l'autre filtre de dispersion (16) présentant un temps de propagation augmentant de façon monotone avec la fréquence et les deux filtres de dispersion (15, 16) étant connectés côté sortie aux entrées d'un additionneur (17) ou d'un soustracteur (18) ou d'un multiplicateur (19).

**16.** Dispositif émetteur pour exécuter les étapes de procédé côté émetteur d'un procédé selon l'une quelconque des revendications 1 à 6,
comprenant un émetteur pour recevoir et transmettre un signal d'entrée (2i) transportant des informations,
**caractérisé en ce que**
pour la génération d'au moins deux impulsions comprimées (2e, 2f) à modulation de fréquence opposée dans le temps, l'émetteur présente au moins deux générateurs d'impulsions (1 à 5 et 6 ou 7) qui sont reliés côté sortie à un premier élément de superposition (8, 9) pour générer une impulsion repliée (2g, 2h) respectivement à partir de deux impulsions comprimées (2e, 2f) à modulation de fréquence opposée, et
**en ce que** l'émetteur présente un modulateur (11) pour appliquer aux impulsions repliées (2g, 2h) les informations contenues dans le signal d'entrée (2i).

**17.** Dispositif récepteur pour exécuter les étapes de procédé côté récepteur d'un procédé selon l'une quelconque des revendications 1 à 6,
comprenant un récepteur pour récupérer un signal d'entrée (2i) transportant des informations,
**caractérisé en ce que**
le récepteur présente deux filtres de dispersion (34, 35, 41, 42, 49, 50) avec une caractéristique de temps de propagation sélective pour la mise en forme des impulsions repliées (2g, 2h) reçues, la caractéristique de temps de propagation sélective des deux filtres de dispersion (34, 35, 41, 42, 49, 50) étant adaptée à la modulation de fréquence respectivement d'une des deux impulsions (2e, 2f) constituant par leur superposition l'impulsion repliée (2g, 2h), de telle sorte qu'à la sortie des deux filtres de dispersion (34, 35, 41, 42, 49, 50) apparaît respectivement un signal combiné (2k, 2l) qui se compose d'une impulsion comprimée dans le temps avec une amplitude accrue de façon correspondante et d'une impulsion étendue dans le temps avec une amplitude réduite de façon correspondante,
et **en ce qu'**à la suite des deux filtres de dispersion (34, 35, 41, 42, 49, 50) prévus côté récepteur est placé un deuxième élément de superposition (36, 43, 46, 51, 52, 61) qui regroupe les signaux de sortie des deux filtres de dispersion (34, 35, 41, 42, 49, 50).

Fig.1a

EP 1 126 625 B1

Fig. 1b

Fig. 1c

Fig. 1d

Fig. 1e

EP 1 126 625 B1

Fig. 1f

Fig.2a

Fig.2b

Fig.2c

Fig.2d

Fig.2e

Fig.2f

Fig.2g

Fig.2h

Fig.2i

Fig.2j

Fig. 2k

Fig. 2l

Fig. 2m

Fig. 2n

Fig. 2o

Fig. 2p

Fig. 3a

EP 1 126 625 B1

Fig. 3b

EP 1 126 625 B1

30

Fig. 3c

Fig. 3d